# EUROPEAN PATENT SPECIFICATION

(11) **EP 3 446 875 B1**
(45) Date of publication and mention of the grant of the patent: **02.06.2021**
(21) Application number: 17785681.2
(22) Date of filing: 06.03.2017
(51) Int. Cl.: B41F 3/56, B41F 3/34, B41F 33/00, H05K 3/12, B41F 3/04, B41F 3/22, B41F 3/26, B41F 27/00, B41F 33/02, B41F 33/16

(54) **TRANSFER APPARATUS AND METHOD FOR AN ELECTRONIC DEVICE**
TRANSFERVORRICHTUNG UND -VERFAHREN FÜR EIN ELEKTRONISCHES GERÄT
APPAREIL ET PROCÉDÉ DE TRANSFERT POUR UN DISPOSITIF ÉLECTRONIQUE

(30) Priority: 22.04.2016 JP 2016086397
(43) Date of publication of application: 27.02.2019
(73) Proprietor: Shashin Kagaku Co., Ltd., Karasuma-dori, Nakagyo-ku Kyoto-shi Kyoto 604-0847 (JP)
(72) Inventor: KITAZAWA, Hiroyuki, Kyoto-shi Kyoto 604-0847 (JP)
(74) Representative: Goddar, Heinz J.
(86) International application number: PCT/JP2017/008819
(87) International publication number: WO 2017/183338

(56) References cited:
- WO-A1-2006/062107
- JP-A- 2010 280 164
- JP-A- 2011 218 584
- JP-A- 2011 218 584
- JP-A- 2012 206 432
- KR-A- 20110 011 461
- KR-A- 20130 053 192
- US-A- 5 367 953
- US-A1- 2007 151 469
- US-A1- 2012 067 232

## Description

### [Technical Field]

The present invention relates to a transfer device for an electronic device and a transfer method for the electronic device.

### [Background Art]

In the steps for manufacturing a liquid crystal display device or a printed circuit board a photolithography technique is used in order to form a pattern such as an electrode and a wire on various types of substrates. The photolithography technique enables formation of fine patterns with high accuracy.

In recent years, a method of forming a pattern such as an electrode and a wire on a substrate using a print technique with use of conductive ink instead of the photolithography technique has been suggested. The print technique is used, so that the number of steps required for the formation of a pattern is reduced.

Offset printing can be utilized to form a pattern. In the offset printing, ink is transferred to a blanket roller from an inked plate. Thereafter, the transferred ink is re-transferred to an object such as a substrate from the blanket roller. Regarding the offset printing, various methods have been suggested in order to improve measurement accuracy of the transferred ink pattern.

For example, an offset printing device described in Patent Document 1 includes a plate table, a print subject table and a blanket roller. Each of the plate table and the print subject table is provided to be movable in one direction independently on a guide rail. The blanket roller is provided at a fixed position above the guide rail.

When the offset printing is carried out, a plate is first aligned while being placed on the plate table. Further, an object is aligned while being placed on the print subject table. Next, the plate table is moved in one direction, so that the plate is conveyed to a lower position of the blanket roller while being inked. The plate table is moved in the one direction and the blanket roller is rotated, so that ink is transferred to the blanket roller from the plate.

Subsequently, the print subject table is moved in the one direction, so that the object is conveyed to a lower position of the blanket roller. When the object is moved in the one direction, and the blanket roller is rotated, the ink is re-transferred from the blanket roller to the object.

In the above-mentioned offset printing device, the plate and the object are respectively aligned, whereby a reduction in measurement accuracy of an ink pattern caused by an error of an attachment position of the plate to the plate table and an error of an attachment position of the object to the print subject table is reduced.

[Patent Document 1] JP 2010-280164 A

Furthermore, the document US 2012/067232 A1 discloses a transfer device for an electronic device, the transfer device being able to carry out calibration using a calibration plate having first and second alignment marks arranged in a first direction and third and fourth alignment marks arranged in a second direction orthogonal to said first direction, and transferring a transfer article that forms part of the electronic device to an object, comprising a table having a support surface that can support the calibration plate and the object, a table supporter that supports the table such that the table is movable in said first and second directions that are parallel to this support surface and orthogonal to each other, and supports the table such that the table is rotatable about an axis orthogonal to the support surface, a movement driver that moves the table supporter in the first direction, a transfer roller that has a rotation shaft and an outer peripheral surface that can hold the transfer article, a shaft supporter that supports the transfer roller such that the transfer roller is rotatable about the rotation shaft, a rotation driver that rotates the transfer roller, a first imager, a second imager, a third imager and a fourth imager provided at a predetermined fixed alignment position, which defines a reference position for the calibration alignment.

### [Summary of Invention]

### [Technical Problem]

Due to high density and high integration of devices in recent years, formation of finer patterns on a substrate has become an important issue. Therefore, higher measurement accuracy is also required for ink patterns to be formed on the substrate by the offset printing.

An object of the present invention is to provide a transfer device for an electronic device and a transfer method for the electronic device which enable a transfer article forming part of the electronic device to be transferred to a desired position of an object with high accuracy.

### [Solution to Problem]

The cause of a reduction in measurement accuracy of the ink pattern after the printing in the offset printing device is not limited to the error of the attachment position of the plate to the plate table and the error of the attachment position of the object to the print subject table. In a transfer device for an electronic device utilizing the offset printing technique, the inventors of the present invention paid attention to an error in an assembly of a plurality of constituent elements, and reached the following invention to reduce a reduction in measurement accuracy caused by the assembly error and an increase in measurement error generated over time due to the use of the transfer device.

A transfer device for an electronic device according to one aspect of the present invention is provided in claim 1.

In the transfer device, the calibration plate is supported on the support surface of the table during calibration. When the table supporter is in the first position with the calibration plate supported by the table, the image of the first alignment mark that is imaged by the first imager is displayed in the display. Thus, the user can adjust the position of the first imager independently from the table supporter such that the first reference index is positioned on the first alignment mark when the table supporter is in the first position.

When the table supporter is in the second position with the calibration plate supported by the table, the image of the second alignment mark that is imaged by the first imager is displayed in the display. Thus, the user can adjust the position of the table supporting the calibration plate by the table supporter such that the first reference index is positioned on the first alignment mark when the table supporter is in the first position, and can adjust the position of the table supporting the calibration plate by the table supporter such that the first reference index is positioned on the second alignment mark when the table supporter is in the second position. In this case, the first and second alignment marks are arranged in the one direction of the calibration plate, so that the one direction of the calibration plate is parallel to the first direction. Further, the other direction of the calibration plate is parallel to the second direction.

When the table supporter is in the third position with the calibration plate supported by the table, the image of the third alignment mark that is imaged by the first imager is displayed in the display, and the image of the fourth alignment mark that is imaged by the second imager is displayed in the display. Thus, the user can adjust the position of the first imager independently from the table such that the first reference index is positioned on the third alignment mark when the table supporter is in the third position. Further, the user can adjust the position of the second imager independently from the table such that the second reference index is positioned on the fourth alignment mark when the table supporter is in the third position. In this case, the third and fourth alignment marks are arranged in the other direction of the calibration plate, so that the first reference index of the first imager and the second reference index of the second imager are accurately arranged in the second direction.

When the table supporter is in the third position with the calibration plate supported by the table, the image of the third alignment mark that is imaged by the third imager is displayed in the display, and the image of the fourth alignment mark that is imaged by the fourth imager is displayed in the display. Thus, the user can adjust the position of the third imager relative to the table such that the third reference index is positioned on the third alignment mark when the table supporter is in the third position. Further, the user can adjust the position of the fourth imager relative to the table such that the fourth reference index is positioned on the fourth alignment mark when the table supporter is in the third position. In this case, because the third and fourth alignment marks are arranged in the other direction of the calibration plate, the third reference index of the third imager and the fourth reference index of the fourth imager are accurately arranged in the second direction.

When the table supporter is moved from the third position to the fourth position by the movement driver, the third and fourth imagers are moved in the first direction together with the table supporter while the positional relationship between the third reference index and the fourth reference index is maintained.

When the table supporter is in the fourth position, the image of the reference line of the transfer roller that is imaged by the third imager is displayed in the display, and the image of the reference line of the transfer roller that is imaged by the fourth imager is displayed in the display. Thus, the user can adjust the orientation of the rotation shaft of the transfer roller in the plane parallel to the support surface such that the third reference index and the fourth reference index are respectively positioned on the reference line of the transfer roller when the table support position is in the fourth position. In this case, because the third reference index of the third imager and the fourth reference index of the fourth imager are accurately arranged in the second direction, the reference line of the transfer roller becomes parallel to the plane orthogonal to the first direction. In this manner, the deviation of the rotation shaft of the transfer roller caused by an error in an assembly of a plurality of constituent elements of the transfer device or the like is reduced. Thus, the transfer article can be transferred to the desired position of the object with high accuracy.

The object is supported on the support surface of the table during transfer. When the object has two alignment marks at positions corresponding to the third and fourth alignment marks in the calibration plate, the position of the object can be adjusted using these two alignment marks.

For example, the table supporter is moved to the third position with the object supported. At this time, the image of the one alignment mark that is imaged by the first imager is displayed in the display, and an image of the other alignment mark that is imaged by the second imager is displayed in the display. Thus, the user can adjust the position of the table supporting the object by the table supporter such that the first reference index and the second reference index are positioned on the one alignment mark and the other alignment mark, respectively. In this case, the direction in which the two alignment marks on the object are arranged can be made parallel to the plane orthogonal to the first direction. Further preferred embodiments of the transfer device according to the invention are defined in the dependent claims 2-4.

The transfer device for the electronic device may further include a first detector that moves together with the table supporter and detects a distance from a first detection position to an outer peripheral surface of the transfer roller, and a second detector that moves together with the table supporter and detects a distance from a second detection position to the outer peripheral surface of the transfer roller, wherein the first detection position and the second detection position may be positioned on a common line extending in the second direction to be separated from each other, and the transfer roller may further be provided such that an orientation of the rotation shaft is adjustable in a plane parallel to the second direction and a third direction that is orthogonal to the support surface.

In this case, the table supporter moves in the first direction, whereby the distance from each of the plurality of first detection positions to the outer peripheral surface of the transfer roller in the first direction can be detected by the first detector. Thus, the shortest distance from the first detector to the outer peripheral surface of the transfer roller in the case where the table supporter moves in the first direction can be acquired.

Further, the table supporter moves in the first direction, whereby the distance from each of the plurality of second detection positions to the outer peripheral surface of the transfer roller in the first direction can be detected by the second detector. Thus, the shortest distance from the second detector to the outer peripheral surface of the transfer roller in the case where the table supporter moves in the first direction can be acquired.

The first detection position and the second detection position are positioned on the common line extending in the second direction to be separated from each other. Thus, the user can adjust the orientation of the rotation shaft of the transfer roller in the plane parallel to the second and third directions such that the shortest distance from the first detection position to the outer peripheral surface of the transfer roller coincides with the shortest distance from the second detection position to the outer surface of the transfer roller. In this case, the first and second detection positions are respectively set on the support surface, whereby the axial center of the rotation shaft of the transfer roller can be parallel to the support surface. Thus, the reference line of the transfer roller becomes parallel to the support surface. Therefore, the above-mentioned calibration is carried out in this state, whereby the transfer article can be transferred to the desired position of the object with higher accuracy.

The transfer article may be held by a sheet-like member configured to be attachable to and detachable from the transfer roller, the sheet-like member may have fifth and sixth alignment marks, an outer peripheral surface of the transfer roller may include seventh and eighth alignment marks arranged in a direction parallel to the rotation shaft, the transfer device may further include a fifth imager that has a field-of-view including a fifth reference index, images the seventh alignment mark when the transfer roller is at a predetermined rotation angle with the sheet-like member not attached to the transfer roller, and images the fifth alignment mark when the transfer roller is at the predetermined rotation angle with the sheet-like member attached to the transfer roller, and a sixth imager that has a field-of-view including a sixth reference index, images the eighth alignment mark when the transfer roller is at the predetermined rotation angle with the sheet-like member not attached to the transfer roller, and images the sixth alignment mark when the transfer roller is at the predetermined rotation angle with the sheet-like member attached to the transfer roller, the display may further display images that are imaged by the fifth and sixth imagers, and the fifth and sixth imagers may be provided such that positions of the fifth and sixth imagers are adjustable independently from the transfer roller.

In this case, when the transfer roller is at the predetermined rotation angle with the sheet-like member not attached during calibration, the image of the seventh alignment mark that is imaged by the fifth imager is displayed in the display, and the image of the eighth alignment mark that is imaged by the sixth imager is displayed in the display. Thus, the user can adjust the position of the fifth imager independently from the transfer roller such that the fifth reference index is positioned on the seventh alignment mark when the transfer roller is at the predetermined rotation angle. Further, the user can adjust the position of the sixth imager independently from the transfer roller such that the sixth reference index is positioned on the eighth alignment mark when the transfer roller is at the predetermined rotation angle. In this case, the seventh and eighth alignment marks are arranged in the direction parallel to the rotation shaft, the fifth reference index of the fifth imager and the sixth reference index of the sixth imager are arranged accurately in the direction of the rotation shaft.

Thereafter, when the transfer roller is at the predetermined rotation angle with the sheet-like member attached during the transfer, the image of the fifth alignment mark that is imaged by the fifth imager is displayed in the display, and the image of the sixth alignment mark that is imaged by the sixth imager is displayed in the display. Thus, the user can detect an amount of deviation between the fifth reference index and the fifth alignment mark. Further, the user can detect an amount of deviation between the sixth reference index and the sixth alignment mark. These amounts of deviation indicate an error when the transfer article is transferred from the sheet-like member to the object. As such, the user can correct the position of the object supported by the table or correct a transfer condition such as a rotation state of the transfer roller and a movement state of the table such that the detected amount of deviation is offset.

The transfer device for the electronic device may have a plurality of the transfer rollers, wherein the shaft supporter may be configured to rotatably support each of the plurality of transfer rollers, the rotation driver may be configured to respectively rotate the plurality of transfer rollers, and the fourth position may be set as each of a plurality of positions respectively corresponding to the plurality of transfer rollers.

In this case, when the table supporter is in each fourth position, the image of the reference line of each transfer roller that is imaged by the third imager is displayed in the display, and the image of the reference line of each transfer roller that is imaged by the fourth imager is displayed in the display. Thus, the user can adjust the orientation of the rotation shaft of each transfer roller in the plane parallel to the support surface such that the third reference index and the fourth reference index are positioned on the reference line of each transfer roller when the table supporter is in each fourth position. Thus, the reference line of each transfer roller is parallel to the plane orthogonal to the first direction. Therefore, the deviation of the rotation shaft of each transfer roller is reduced. Thus, the plurality of transfer articles can be transferred to a desired position of the object with high accuracy using the plurality of transfer rollers.

Additionally, a transfer method for an electronic device according to another aspect of the present invention is provided in claim 5 and includes the steps of: preparing the transfer device for the electronic device, calibrating the transfer device, and transferring a transfer article to an object using the calibrated transfer device, wherein the calibrating includes arranging the calibration plate on the support surface of the table, moving the table supporter to the first position and displaying an image of the first alignment mark imaged by the first imager in the display with the calibration plate supported by the table, adjusting a position of the first imager such that the first reference index of the first imager is positioned on the first alignment mark when the table supporter is in the first position with the calibration plate supported by the table, moving the table supporter to the second position and displaying an image of the second alignment mark that is imaged by the first imager in the display with the calibration plate supported by the table after the adjusting the position of the first imager, adjusting a position of the table supporting the calibration plate by the table supporter such that the first reference index of the first imager is positioned on the first alignment mark when the table supporter is in the first position with the calibration plate supported by the table, and adjusting the position of the table supporting the calibration plate by the table supporter such that the first reference index of the first imager is positioned on the second alignment mark when the table supporter is in the second position with the calibration plate supported by the table, after the adjusting the position of the first imager, moving the table supporter to the third position and displaying an image of the third alignment mark that is imaged by the first imager, an image of the fourth alignment mark that is imaged by the second imager, an image of the third alignment mark that is imaged by the third imager, and an image of the fourth alignment mark that is imaged by the fourth imager with the calibration plate supported by the table after the adjusting the position of the table, adjusting a position of the first imager such that the first reference index of the first imager is positioned on the third alignment mark, adjusting a position of the second imager such that the second reference index of the second imager is positioned on the fourth alignment mark, adjusting a relative positional relationship between the third imager and the table such that the third reference index of the third imager is positioned on the third alignment mark, and adjusting a relative positional relationship between the fourth imager and the table such that the fourth reference index of the fourth imager is positioned on the fourth alignment mark, after displaying the images of the first to fourth alignment marks in the display, moving the table supporter to the fourth position and displaying an image of a reference line of the transfer roller that is imaged by the third imager and an image of a reference line of the transfer roller that is imaged by the fourth imager in the display with the calibration plate removed from the table after the adjusting the first to fourth imagers, and adjusting an orientation of the rotation shaft of the transfer roller in a plane parallel to the support surface after the displaying the image of the reference line such that the third reference index of the third imager and the fourth reference index of the fourth imager are respectively positioned on the reference line.

With this transfer method, the above-mentioned transfer device for the electronic device is prepared, and the prepared transfer device is calibrated. The transfer article is transferred to the object using the transfer device after calibration.

With the above-mentioned steps of calibrating the transfer device, the third reference index of the third imager and the fourth reference index of the fourth imager are adjusted to be accurately arranged in the second direction. The orientation of the rotation shaft of the transfer roller is adjusted in the plane parallel to the support surface based on the third reference index and the fourth reference index. Thus, the reference line of the transfer roller is parallel to the plane orthogonal to the first direction. Therefore, the deviation of the rotation shaft of the transfer roller caused by an error in an assembly of the plurality of constituent elements of the transfer device or the like is reduced. As a result, the transfer article can be transferred to the desired position of the object with high accuracy.

### [Advantageous Effects of Invention]

The present invention enables a transfer article being part of an electronic device to a desired position of an object with high accuracy.

### [Brief Description of the Drawings]

[FIG. 1] Fig. 1 is an external perspective view of a transfer device for an electronic device according to one embodiment of the present invention.
[FIG. 2] Fig. 2 is a schematic side view of the transfer device of Fig. 1.
[FIG. 3] Fig. 3 is a block diagram showing a control system of the transfer device of Fig. 1.
[FIG. 4] Fig. 4 is a plan view of a calibration plate.
[FIG. 5] Fig. 5 is a diagram showing one example of reference indices set in fields-of-view of cameras.
[FIG. 6] Fig. 6 is a diagram for explaining one example of steps of calibrating the transfer device.
[FIG. 7] Fig. 7 is a diagram for explaining the one example of the steps of calibrating the transfer device.
[FIG. 8] Fig. 8 is a diagram for explaining the one example of the steps of calibrating the transfer device.
[FIG. 9] Fig. 9 is a diagram for explaining the one example of the steps of calibrating the transfer device.
[FIG. 10] Fig. 10 is a diagram for explaining the one example of the steps of calibrating the transfer device.
[FIG. 11] Fig. 11 is a diagram for explaining the one example of the steps of calibrating the transfer device.
[FIG. 12] Fig. 12 is an external perspective view of the transfer device showing steps of detecting a position deviation of a sheet-like member attached to the transfer roller.
[FIG. 13] Fig. 13 is an external perspective view of a transfer device for an electronic device according to the other embodiment.

### [Description of Embodiments]

A transfer device for an electronic device and a transfer method for the electronic device according to one embodiment of the present invention will be described below with reference to drawings. In the following description, the transfer means that part or all of functional materials that constitutes the electronic device, or part or all of electronic components that constitutes the electronic device is transferred to an object as a transfer article. The functional materials that constitute the electronic device include conductive ink such as nano-silver ink or insulation film materials to be placed among a plurality of layers provided in a stack for insulation. Further, the electronic components include a predetermined element or a chip on which the predetermined element is mounted.

### [1] Basic Configuration of Transfer Device for Electronic Device

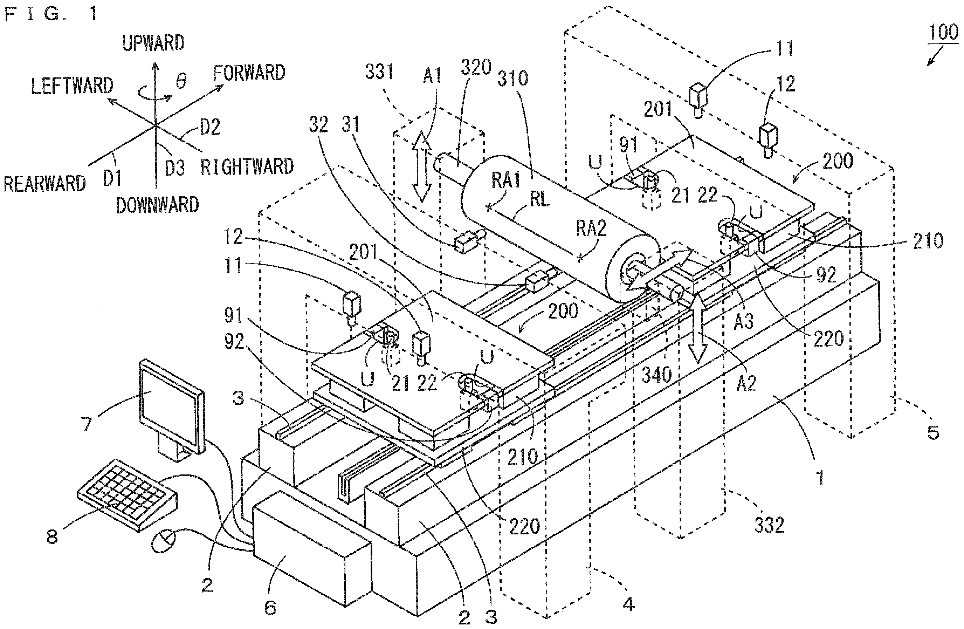

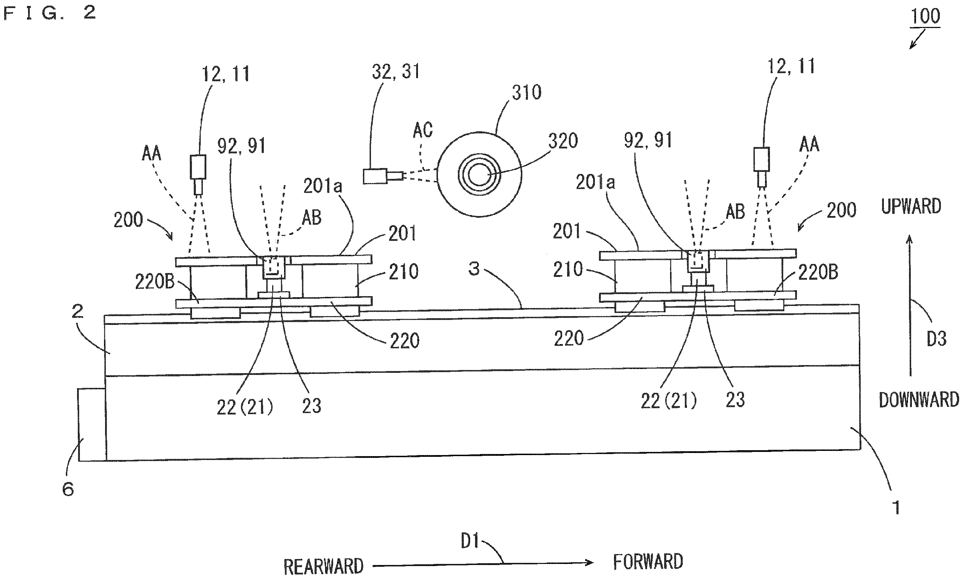

Fig. 1 is an external perspective view of the transfer device for the electronic device according to one embodiment of the present invention, and Fig. 2 is a schematic side view of the transfer device 100 of Fig. 1. In Fig. 1, a plurality of constituent elements are partially indicated by dotted lines in order to facilitate understanding of an internal structure of the transfer device 100. In Fig. 2, the constituent elements of the transfer device 100 of Fig. 1 are partially not shown.

As shown in Fig. 1, the transfer device 100 has a base 1 that is formed to extend in one direction. In the transfer device 100, a front-and-rear direction D1 is defined as a direction in which the base 1 extends. Further, a left-and-right direction D2 is defined as a direction orthogonal to the front-and-rear direction D1, and an up-and-down direction D3 is defined as a direction orthogonal to the front-and-rear direction D1 and the left-and-right direction D2. Further, a rotation direction centered at an axis parallel to the up-and-down direction D2 is a θ direction.

In the present example, the front-and-rear direction D1 and the left-and-right direction D2 are orthogonal to each other in a horizontal plane. In the following description, the direction in which the arrow is directed in the front-and-rear direction D1 is referred to as forward, and the opposite direction is referred to as rearward. Further, the direction in which the arrow is directed in the left-and-direction D2 is referred to as leftward, and the opposite direction is referred to as rightward. Further, the direction in which the arrow is directed in the up-and-down direction D3 is referred to as upward, and the opposite direction is referred to as downward.

A controller 6 is provided at a rear end of the base 1. A display 7 and an operation unit 8 are connected to the controller 6. Details of the controller 6, the display 7 and the operation unit 8 are described below.

Two main bases 2 having a cuboid shape are provided on the base 1 to extend in the front-and-rear direction D1. The two main bases 2 are arranged in parallel to each other with a certain space provided therebetween. Two rails 3 are respectively attached onto the two main bases 2. The two rails 3 are fixed horizontally to be arranged at the same height in parallel to each other and extend in the front-and-rear direction D1. Two table devices 200 are provided on the two rails 3 to be arranged in the front-and-rear direction D1. Each table device 200 is configured to be movable in the direction in which the rail 3 extends (the front-and-rear direction D1).

Specifically, as shown in Fig. 2, the table device 200 is mainly constituted by a table 201, a table supporter 210 and a movement driver 220. The movement driver 220 includes a transport base 220B that moves on the rail 3. Further, the movement driver 220 has a driver (not shown) that moves the transport base 220B in the front-and-rear direction D1. An encoder for detecting the position of the table device 200 in the front-and-rear direction D1 is provided at the movement driver 220. An output signal of the encoder is supplied to the controller 6.

The table supporter 210 is provided on the transport base 220B, and the table 201 is provided on the table supporter 210. The table 201 is constituted by a substantially square plate-shape member and has a support surface 201a facing upward. The support surface 201a is formed to be parallel to the front-and-rear direction D1 and the left-and-right direction D2 and be able to selectively support a planar transfer-receiving object to which a transfer article is to be transferred, a planar plate and a below-mentioned calibration plate CP. The table 201 may be configured to be able to hold the object, the plate and the calibration plate CP on the support surface 201a by suction. Alternatively, the table 201 may be configured to be chuckable of the object, the plate and the calibration plate CP.

The table 201 is supported by the table supporter 210 to be movable in the front-and-rear direction D1 and the left-and-right direction D2 with respect to the transport base 220B and to be rotatable in the θ direction with respect to the transport base 220B. Further, the table supporter 210 has a driver (not shown) that moves the table 201 in the front-and-rear direction D1 and the left-and-right direction D2 with respect to the transport base 220B and rotates the table 201 in the 8 direction with respect to the transport base 220B. The table supporter 210 is provided with a plurality of encoders for detecting a movement amount of the table 201 in the front-and-rear direction D1 and the left-and-right direction D2 with respect to the transport base 220B and a rotation amount of the table 201 in the θ direction with respect to the transport base 220B. Output signals of the plurality of encoders are supplied to the controller 6.

As shown in Fig. 1, two roiier support devices 331, 332 are provided to sandwich a substantially center portion of the base 1 in the front-and-rear direction D1. The roller support devices 331, 332 are integrally fixed to the base 1. A transfer roller 310 is provided between the roller support devices 331, 332. The transfer roller 310 has a rotation shaft 320 and has an outer peripheral surface that can hold a transfer article.

Alignment marks RA1, RA2 and a reference line RL are provided in part of the outer peripheral surface of the transfer roller 310 to be arranged in the direction parallel to the rotation shaft 320. The reference line RL is positioned between the alignment marks RA1, RA2 and extends in parallel to the rotation shaft 320. The alignment marks RA1, RA2 and the reference line RL may be formed by cutting of the outer peripheral surface of the transfer roller 310, may be formed by a laser process of the outer peripheral surface of the transfer roller 310 or may be formed by paint, for example.

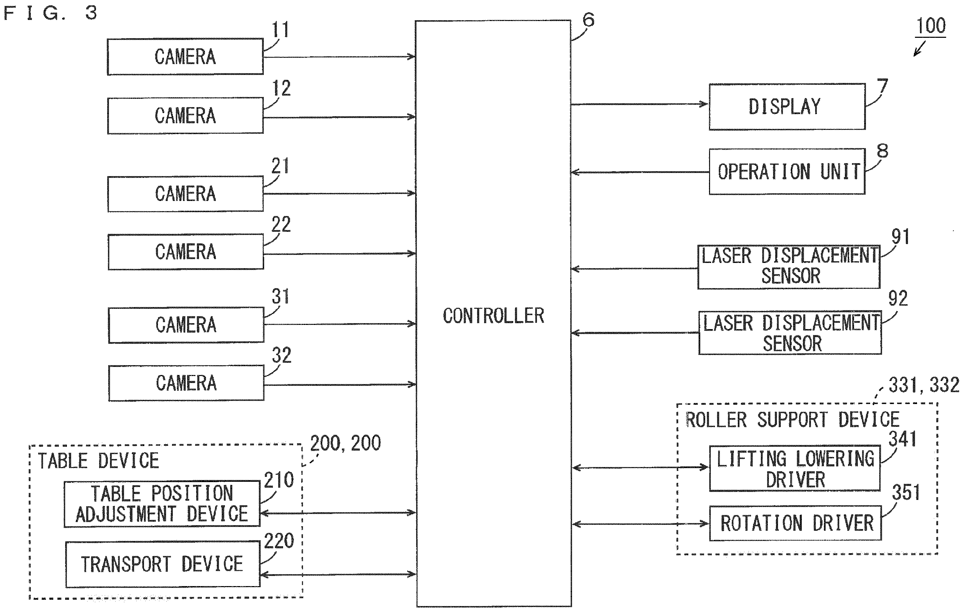

The roller support devices 331, 332 respectively and rotatably support one end and the other end of the rotation shaft 320 of the transfer roller 310. Further, each of the roller support devices 331, 332 has a lift-lower driver 341 (Fig. 3, described below) and a rotation driver 351 (Fig. 3, described below).

As indicated by outlined arrows A1, A2 in Fig. 1, the lift-lower driver 341 (Fig. 3) rotatably supports each end of the rotation shaft 320 and moves a support position of each end in the up-and-down direction D3. The lift-lower driver 341 is provided with an encoder for detecting a movement amount of the support position of each end of the rotation shaft 320 in the up-and-down direction D3. An output signal of the encoder is supplied to the controller 6. It is possible to adjust the orientation of the rotation shaft 320 in the plane parallel to the left-and-right direction D2 and the up-and-down direction D3 by independently controlling the lift-lower driver 341 (Fig. 3) of each of the roller support devices 331, 332.

The rotation driver 351 (Fig. 3) rotates the transfer roller 310. The rotation driver 351 is provided with an encoder for detecting a change amount of the rotation angle of the rotation shaft 320. An output signal of the encoder is supplied to the controller 6.

The roller support device 332 is provided with a rotation shaft adjustment mechanism 340 that is configured to be operable by a user. As indicated by the outlined arrow A3 in Fig. 1, the rotation shaft adjustment mechanism 340 can move the support position of the other end of the rotation shaft 320 supported by the roller support device 332 in the front-and-rear direction D1. It is possible to adjust the orientation of the rotation shaft 320 in the plane parallel to the support surface 201a (Fig. 2) by operating the rotation shaft adjustment mechanism 340.

A first main body 4 is provided at a position farther rearward than the transfer roller 310 to surround a movement path of the table device 200, which moves on the rail 3, in the left-and-right direction D2 and from above. The first main body 4 is integrally fixed to the base 1. The first main body 4 is provided with a plurality (four in the present example) of cameras 11, 12, 31, 32. As each camera 11, 12, 31, 32, a CCD (charge-couple device) camera having an objective lens with fixed magnification, for example, is used.

The first main body 4 supports each of the cameras 11, 12 such that the positions of the cameras 11, 12 can be adjusted independently from the table device 200 and the transfer roller 310. As shown in Fig. 2, each of the cameras 11, 12 is arranged such that a field-of-view AA is basically directed downward from above the movement path of the table device 200. Further, as shown in Fig. 1, the first main body 4 supports each of the cameras 31, 32 such that the positions of the cameras 31, 32 can be adjusted independently from the table device 200 and the transfer roller 310. As shown in Fig. 2, each of the cameras 31, 32 is arranged such that a field-of-view AC is basically directed forward and towards a portion of the outer peripheral surface of the transfer roller 310.

As shown in Fig. 1, a second main body 5 is provided at a position farther forward than the transfer roller 310 to surround the movement path of the table device 200, which moves on the rail 3, in the left-and-right direction D2 and from above. The second main body 5 is integrally fixed to the base 1. The second main body 5 is provided with the plurality (two in the present example) of cameras 11, 12. Similarly to the first main body 4, the second main body 5 supports each of the cameras 11, 12 such that the positions of the cameras 11, 12 can be adjusted independently from the table device 200 and the transfer roller 310.

As shown in Fig. 1, each of the two table devices 200 is provided with a plurality (two in the present example) of cameras 21, 22 and a plurality (two in the present example) of laser displacement sensors 91, 92. As each of the cameras 21, 22, a CCD camera having an objective lens with fixed magnification, for example, is used.

The table 201 of each table device 200 is provided with a U-shape cutout U in a center portion of each of two lateral sides extending in the front-and-rear direction D1 and being opposite to each other. The table 201 is supported by the table supporter 210 such that the two cutouts U are arranged in the left-and-right direction D2, for example.

The laser displacement sensors 91, 92 are respectively fixed to the table 201 to be positioned inside of the two cutouts U. Each of the laser displacement sensors 91, 92 is a reflective laser displacement sensor, and has a light emitter and a light receiver. The light emitter emits laser light upward. The light receiver receives the laser light reflected downward and supplies an output signal indicating the distance from a position from which the laser light is emitted to a position from which the laser light is cyclically reflected to the controller 6 in a certain period.

In the present embodiment, a height reference position is set on the support surface 201a (Fig. 2) for the laser displacement sensor 91. When the height reference position of the laser displacement sensor 91 is set on the support surface 201a, a flat plate is arranged on the support surface 201a to cover the laser displacement sensor 91 from above. The flat plate has predetermined flatness. In this state, laser light is emitted from the light emitter of the laser displacement sensor 91, so that the distance from the laser displacement sensor 91 to the support surface 201a can be calculated based on an output signal of the laser displacement sensor 91. The position in the up-and-down direction D3 corresponding to the calculated distance is taken as the height reference position. Thus, with the flat plate removed from the support surface 201a, the distance from the height reference position to the position from which the laser light of the laser displacement sensor 91 is reflected, that is, the distance from the support surface 201a to the position from which the laser light of the laser displacement sensor 91 is reflected can be calculated. Similarly to the example of the laser displacement sensor 91, a height reference position is set on the support surface 201a for the laser displacement sensor 92.

With none of the object, the plate and the calibration plate CP supported on the table 201, one table device 200 is moved in the front-and-rear direction D1 at a certain speed. In this case, when each of the laser displacement sensors 91, 92 passes below the transfer roller 310, the laser light emitted from each of the laser displacement sensors 91, 92 scans the outer peripheral surface of the transfer roller 310 in the front-and-rear direction D1.

Thus, the distance from the height reference position of each of the laser displacement sensor 91, 92 to the outer peripheral surface of the transfer roller 310 is detected at a plurality of positions in the front-and-rear direction D1. Therefore, the shortest distance from the height reference position of the laser displacement sensor 91 to the outer peripheral surface of the transfer roller 310 during the movement of the table device 200 in the front-and-rear direction D1 can be acquired. Further, the shortest distance from the height reference position of the laser displacement sensor 92 to the outer peripheral surface of the transfer roller 310 during the movement of the table device 200 in the front-and-rear direction D1 can be acquired.

The height reference positions of the laser displacement sensors 91, 92 are adjusted to be positioned in a common horizontal plane (the support surface 201a). In this case, the shortest distance detected by the laser displacement sensor 91 can be taken as the height of the lower end of the transfer roller 310 in the vertical plane including the movement path of the laser displacement sensor 91. Further, the shortest distance detected by the laser displacement sensor 92 can be taken as the height of the lower end of the transfer roller 310 in the vertical plane including the movement path of the laser displacement sensor 92.

With the laser displacement sensors 91, 92 arranged in the left-and-right direction D2 and separated from each other, the height of the lower end detected by the laser displacement sensor 91 may be different from the height of the lower end detected by the laser displacement sensor 92. In this case, an axial center of the transfer roller 310 is likely to be inclined with respect to the support surface 201a (Fig. 2). In such a case, the height of the one end and the height of the other end of the rotation shaft 320 are adjusted by control of the lift-lower drivers 341 (Fig. 3) of the roller support devices 331, 332. Thus, the heights of the lower ends detected by the laser displacement sensors 91, 92 can be made equal to each other, and the axial center of the transfer roller 310 can be made parallel to the support surface 201a.

When the table device 200 is viewed from above, the cameras 21, 22 are respectively provided on the movement driver 220 to be positioned inside of the cutouts U of the table 201. More specifically, each of the cameras 21, 22 is provided on the transport base 220B of the movement driver 220 via the adjustment mechanism 23 as shown in Fig. 2. Each of the cameras 21, 22 is supported by the adjustment mechanism 23 to be movable in the front-and-rear direction D1 and the left-and-right direction D2 with respect to the transport base 220B.

Each of the cameras 21, 22 supported by the adjustment mechanism 23 moves in the front-and-rear direction D1 together with the table supporter 210. Each of the cameras 21, 22 is arranged such that a field-of-view AB is basically directed upward.

The controller 6 of Fig. 1 includes a CPU (Central Processing Unit) and a memory, for example. A system program is stored and various data such as a transfer condition is stored in the memory. The CPU executes the system program stored in the memory and controls an operation of each constituent element of the transfer device 100.

The display 7 is constituted by a LCD (Liquid Crystal Display) panel or an organic EL (Electrominessance) panel, for example. The operation unit 8 includes a pointing device such as a mouse and a keyboard, and is operated by a user who inputs predetermined information in the controller 6 or instructs the controller 6 to perform a predetermined operation.

Fig. 3 is a block diagram showing a control system of the transfer device 100 of Fig. 1. As shown in Fig. 3, the output signals from the cameras 11, 12 are supplied to the controller 6. The output signals of the cameras 21, 22 are supplied to the controller 6. The output signals of the cameras 31, 32 are supplied to the controller 6. The controller 6 produces a plurality of image data pieces respectively corresponding to the plurality of output signals supplied from the cameras 11, 12, 21, 22, 31, 32.

The controller 6 can store the plurality of produced image data pieces in an internal memory. Further, the controller 6 allows the display 7 to display a plurality of images based on the plurality of produced image data pieces.

As described above, the output signals from the laser displacement sensors 91, 92 are supplied to the controller 6. The controller 6 calculates the distance from each of the height reference positions of the laser displacement sensors 91, 92 to the position from which the laser light is reflected based on the output signal supplied from each of the laser displacement sensors 91, 92, and allows the display 7 to display the information about the calculated distance as the height information, for example.

The controller 6 is instructed to perform an operation relating to the table device 200 based on a user's operation of the operation unit 8. The controller 6 controls operations of the table supporter 210 and the movement driver 220 based on the given instruction and an output signal of the encoder from the table device 200. At this time, the controller 6 allows the display 7 to display the position of the table device 200 in the front-and-rear direction D1.

The controller 6 is instructed to perform an operation relating to the roller support devices 331, 332 based on a user's operation of the operation unit 8. In this case, the controller 6 controls the operations of the lift-lower driver 341 and the rotation driver 351 based on the given instruction and output signals of the encoders from the roller support devices 331, 332.

Further, a transfer condition for the transfer of a transfer article to a transfer receiving object is input in the controller 6 based on a user's operation of the operation unit 8. In this case, the controller 6 stores the data of the input transfer condition in the internal memory. Further, the controller 6 controls the movement driver 220 of the table device 200 and the rotation drivers 351 of the roller support devices 331, 332 based on the stored transfer condition. The controller 6 may be constituted by a microcomputer instead of the CPU and the memory.

### [2] Example of Use of Transfer Device for Electronic Device

### (1) Calibration

In the transfer device 100 according to the present embodiment, calibration using the calibration plate and the above-mentioned cameras 11, 12, 21, 22, 31, 32 is performed in order to allow a transfer article to be accurately transferred to a design position on an object.

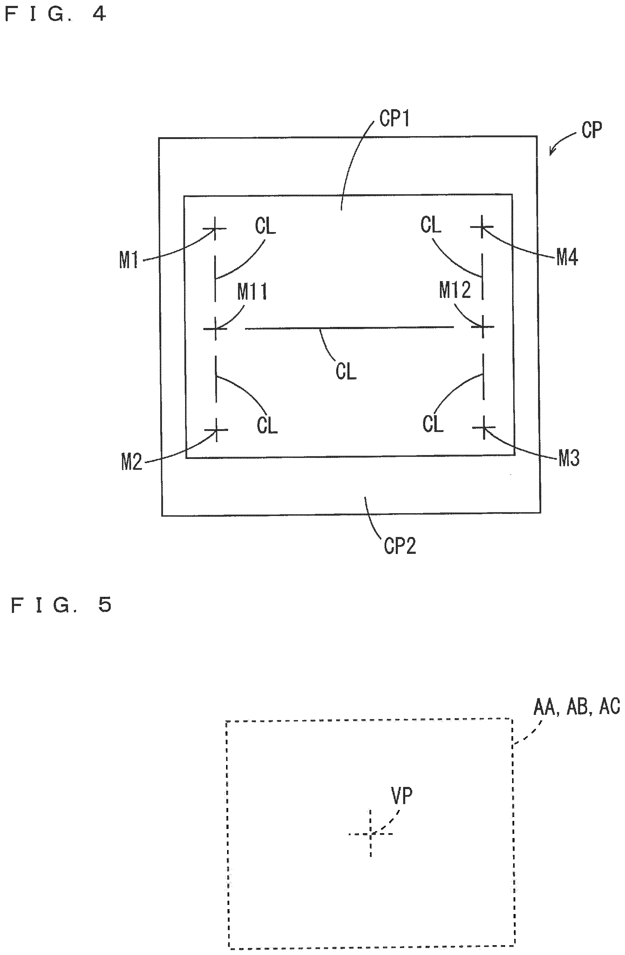

The calibration plate CP will be described. Fig. 4 is a plan view of the calibration plate. The calibration plate CP has the same outer shape as that of the object. As shown in Fig. 4, the calibration plate CP is constituted by a transparent portion CP1 and a frame portion CP2. The transparent portion CP1 is rectangular and is formed of a transparent material such as glass or acryl resin, for example. The frame portion CP2 is formed to surround the transparent portion CP1, has the same outer shape as that of the object and supports the transparent portion CP1. Further, the frame portion CP2 is formed of a metallic material such as aluminum.

Four alignment marks M1, M2, M3, M4 are respectively provided at positions in the vicinity of the four corners of the transparent portion CP1. Two alignment marks M11, M12 are respectively provided in the vicinity of the center portions of a pair of shorter sides of the transparent portion CP1.

The two alignment marks M1, M2 and the one alignment mark M11 provided in the vicinity of one shorter side of the transparent portion CP1 are arranged in one direction parallel to the shorter side. Two linear marks CL extending in the one direction are respectively provided between each of the two alignment marks M1, M2 and the one alignment mark M11.

The two alignment marks M3, M4 and the one alignment mark M12 provided in the vicinity of the other shorter side of the transparent portion CP1 are arranged in the one direction parallel to the shorter side. Respective two linear marks CL extending in the one direction are provided between the respective two alignment marks M3, M4 and the one alignment mark M12.

The two alignment marks M11, M12 are arranged parallel to a pair of longer sides. That is, the two alignment marks M11, M12 are arranged in another direction orthogonal to the above-mentioned one direction. One linear mark CL extending in the other direction is provided between the two alignment marks M11, M12.

A reference index is set for each of the fields-of-view AA for the cameras 11, 12, the fields-of-view AB for the cameras 21, 22 and the fields-of-view AC of the cameras 31, 32. Fig. 5 is a diagram showing one example of the reference index set for each of the fields-of-view AA, AB, AC of each of the cameras 11, 12, 21, 22, 31.

As shown in Fig. 5, the reference index VP is set at the center of each of the fields-of-view AA, AB, AC, for example. In each of the cameras 11, 12, 21, 22, 31, 32, the reference index VP is marked on the objective lens. In this case, the user can easily identify a positional relationship between the reference index VP and an object (the alignment marks M1, M2 of the calibration plate CP, for example) that is present in each of the fields-of-view AA, AB, AC with the image acquired by each of the cameras 11, 12, 21, 22, 31, 32 displayed in the display 7.

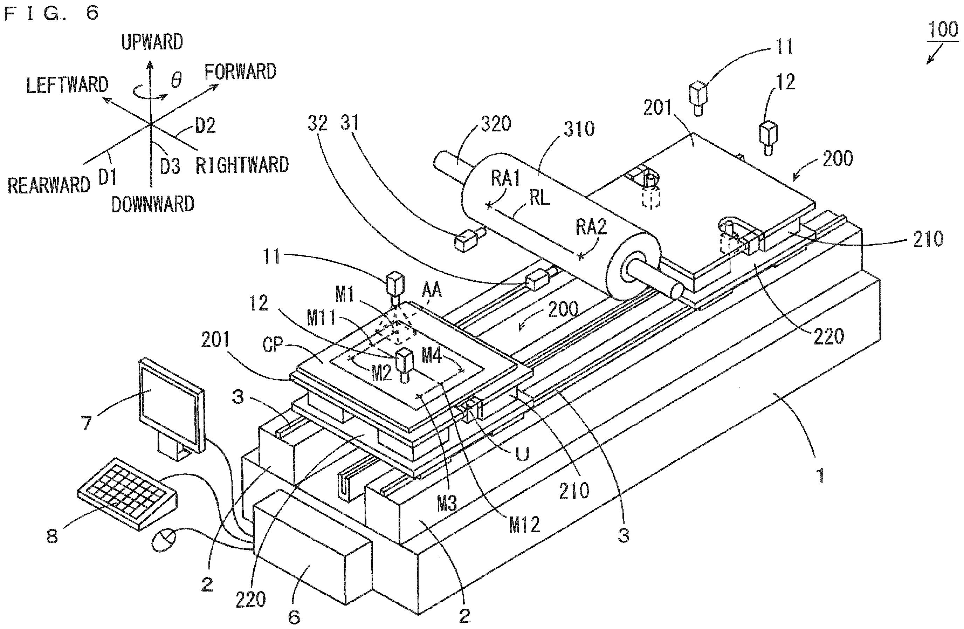

The steps of calibration for performing the accurate transfer between the rear table device 200 and the transfer roller 310 will be described. Figs. 6 to 11 are diagrams for explaining one example of the steps of calibrating the transfer device 100. In Figs. 6, 8, 9 and 11, a plurality of states of the transfer device 100 in the steps of calibration are shown in external perspective views except for part of the constituent elements.

Initially, as shown in Fig. 1, the front table device 200 is moved to the position farther forward than the transfer roller 310, and at the front end or its vicinity of the rail 3. Further, the rear table device 200 is moved to an initial position that is separated rearwardly from the transfer roller 310 by a predetermined distance.

With none of the object, the plate and the calibration plate CP supported on the table 201, the rear table device 200 is moved in the front-and-rear direction D1 at a certain speed to pass through the space below the transfer roller 310. The heights of a plurality of portions at the lower end of the transfer roller 310 are detected based on the output signals of the laser displacement sensors 91, 92 provided at the rear table device 200. When the axial center of the transfer roller 310 is inclined with respect to the support surface 201a (Fig. 2), the axial center of the transfer roller 310 becomes parallel to the support surface 201a (Fig. 2) by adjustment of the height of one end and the height of the other end of the rotation shaft 320.

As described above, the position of the table device 200 in the front-and-rear direction D1 is displayed in the display 7. As such, the user determines the position of the table device 200 in the front-and-rear direction D1 when the laser displacement sensors 91, 92 are positioned below the lower end of the transfer roller 310 as a lower end opposing position. Further, the user records the determined lower end opposing position, and then moves the rear table device 200 to the initial position.

Next, as shown in Fig. 6, the user arranges the calibration plate CP on the table 201 of the rear table device 200. Then, the user visually adjusts the position of the calibration plate CP such that the two alignment marks M11, M12 (Fig. 4) are respectively positioned above the two cutouts U of the table 201. Thus, the alignment marks M1, M11, M2 are roughly arranged in the front-and-rear direction D1. Further, the alignment marks M4, M12, M3 are roughly arranged in the front-and-rear direction D1. Further, the alignment marks M11, M12 are roughly arranged in the left-and-right direction D2.

In this state, the display 7 is allowed to display the image acquired by the camera 11. The user positions the camera 11 while viewing the image displayed in the display 7 such that the reference index VP (Fig. 5) of the camera is positioned on the one alignment mark M1 out of the plurality of alignment marks M1 to M4, M11 and M12. Thereafter, the table device 200 is moved in the front-and-rear direction D1 to a separation position that is separated from the initial position.

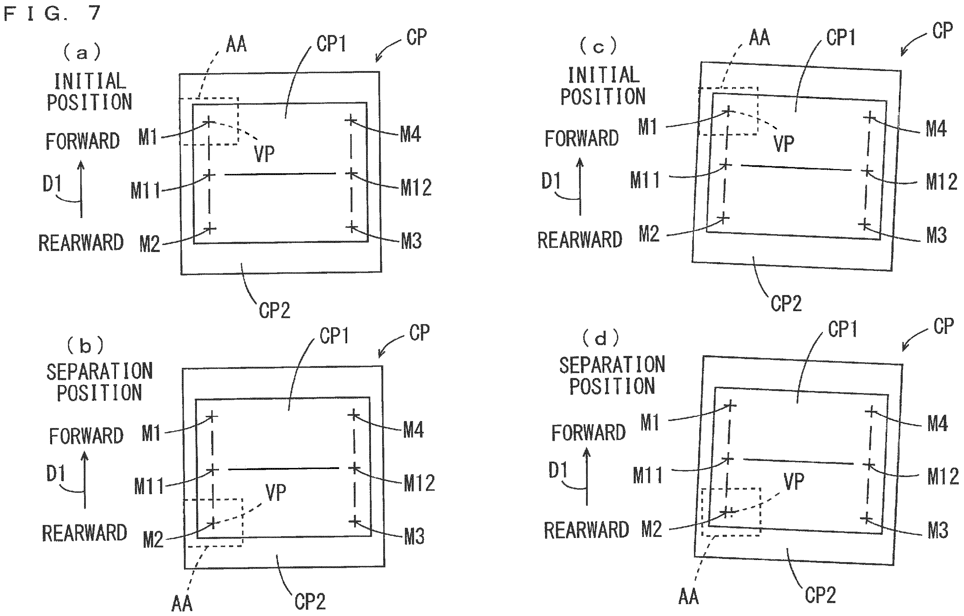

Fig. 7(a) shows one example of the positional relationship between the field-of-view AA of the camera 11 and the calibration plate CP when the table device 200 supporting the calibration plate CP is in the initial position. Fig. 7(b) shows one example of the positional relationship between the field-of-view AA of the camera 11 and the calibration plate CP when the table device 200 supporting the calibration plate CP is in the separation position. Fig. 7(c) shows another example of the positional relationship between the field-of-view AA of the camera 11 and the calibration plate CP when the table device 200 supporting the calibration plate CP is in the initial position. Fig. 7(d) shows another example of the positional relationship between the field-of-view AA of the camera 11 and the calibration plate CP when the table device 200 supporting the calibration plate CP is in the separation position.

As described above, in the calibration plate CP, the two alignment marks M1, M2 are arranged in the one direction, and the two alignment marks M3, M4 are arranged in the one direction. Therefore, in the case where the one direction of the calibration plate CP and the front-and-rear direction D1 are parallel to each other, when the table device 200 moves in the front-and-rear direction D1, the reference index VP of the camera 11 moves in parallel to the one direction of the calibration plate CP. As a result, as shown in Figs. 7(a) and 7(b), the reference index VP of the camera 11 is positioned on the alignment mark M1 when the table device 200 is in the initial position, and is positioned on the alignment mark M2 when the table device 200 is in the separation position.

On the other hand, in the case where the one direction in the calibration plate CP and the front-and-rear direction D1 are not parallel to each other, when the table device 200 moves in the front-and-rear direction D1, the reference index VP of the camera 11 moves in the direction that intersects with the one direction of the calibration plate CP. As a result, as shown in Figs. 7(c) and 7(d), the reference index VP of the camera 11 is positioned on the alignment mark M1 when the table device 200 is in the initial position. However, the reference index VP of the camera 11 deviates from the alignment mark M2 when the table device 200 is in the separation position.

The user adjusts the position in the front-and-rear direction D1, the position in the left-and-right direction D2 and the rotation angle in the θ direction of the table 201 with respect to the transport base 220B (Fig. 2) while viewing the image displayed in the display 7 such that the reference index VP of the camera 11 is positioned on the alignment mark M1 when the table device 200 is in the initial position. The user adjusts the position in the front-and-rear direction D1, the position in the left-and-right direction D2 and the rotation angle in the θ direction of the table 201 with respect to the transport base 220B (Fig. 2) while viewing the image displayed in the display 7 such that the reference index VP of the camera 11 is positioned on the alignment mark M2 when the table device 200 is in the separation position. Thus, the two alignment marks M1, M2 are arranged in the front-and-rear direction D1, and the two alignment marks M3, M4 are arranged in the front-and-rear direction D1. Further, the two alignment marks M11, M12 are arranged in the left-and-right direction D2. This means that the calibration plate CP is positioned such that the one direction and the other direction in the calibration plate CP are respectively parallel to the front-and-rear direction D1 and the left-and-right direction D2.

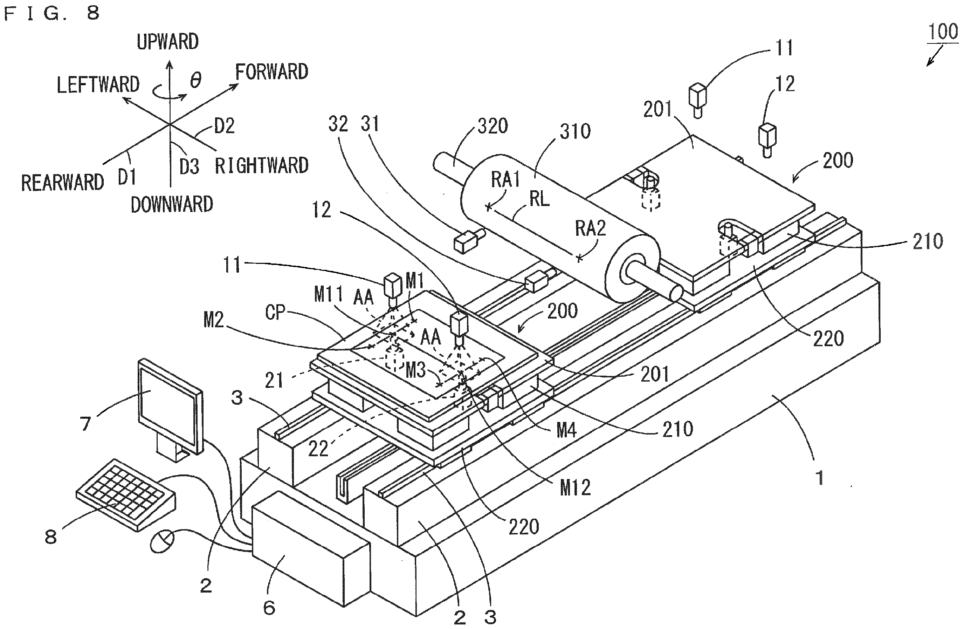

In the case where the reference index VP of the camera 11 moves between the two alignment marks M1, M2 arranged in the one direction, the reference index VP of the camera 11 passes above the alignment mark M11 positioned between the two alignment marks M1, M2. As such, as shown in Fig. 8, the rear table device 200 is moved in the front-and-rear direction D1 such that the reference index VP of the camera 11 is positioned on the alignment mark M11. The position to which the table device 200 has been moved is referred to as a table reference position.

In this state, the display 7 is allowed to display the image acquired by the camera 12. The user positions the camera 12 while viewing the image displayed in the display 7 such that the reference index VP of the camera 12 is positioned on the alignment mark M12. In this case, the two alignment marks M11, M12 are arranged in the left-and-right direction D2, so that the two reference indices VP of the two cameras 11, 12 are accurately arranged in the left-and-right direction D2.

Subsequently, the display 7 is allowed to display respective two images acquired by the cameras 21, 22. The user positions the camera 21 while viewing the image displayed in the display 7 such that the reference index VP of the camera 21 is positioned on the alignment mark M11. Further, the user positions the camera 22 while viewing the image displayed in the display 7 such that the reference index VP of the camera 22 is positioned on the alignment mark M12. Thus, the two reference indices VP of the two cameras 21, 22 are accurately arranged in the left-and-right direction D2.

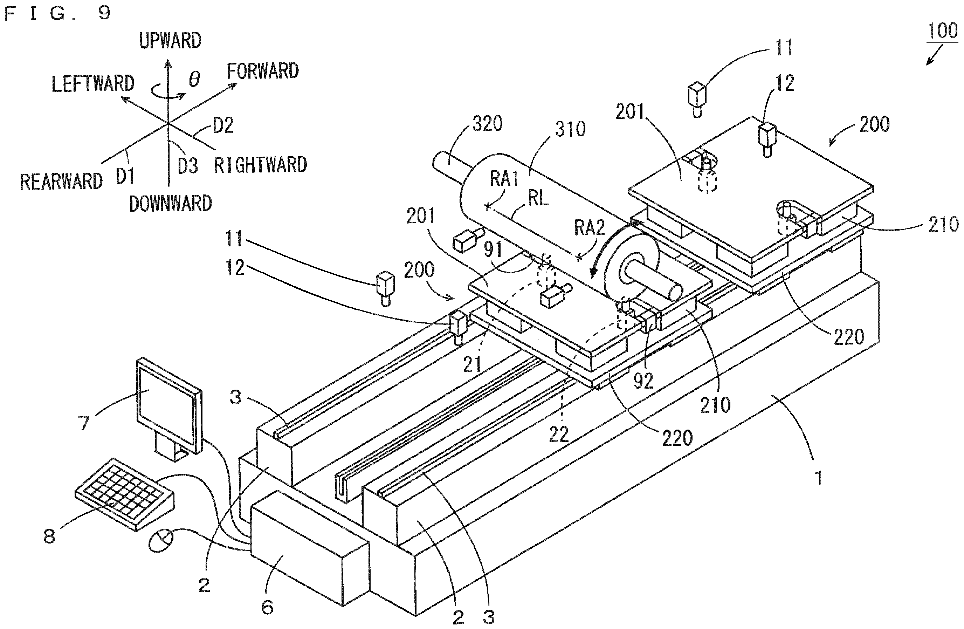

Next, as shown in Fig. 9, the calibration plate CP is removed from the rear table device 200. Further, with none of the object, the plate and the calibration plate CP supported on the table 201, the table device 200 is moved from the table reference position to the lower end opposing position recorded in the previous step. Further, the transfer roller 310 is rotated such that the alignment marks RA1, RA2 and the reference line RL are positioned at the lower end of the outer peripheral surface of the transfer roller 310. In the transfer roller 310, the rotation angle of the rotation shaft 320 in the case where the reference line RL is positioned at the lower end of the outer peripheral surface of the transfer roller 310 is set as a reference angle.

Here, the laser displacement sensors 91, 92 are respectively provided in the vicinity of the cameras 21, 22. Therefore, when the table device 200 is in the lower end opposing position, the lower end of the transfer roller 310 is positioned in the fields-of-view AB (Fig. 2) of the cameras 21, 22. In this state, the two images acquired by the cameras 21, 22 are respectively displayed in the display 7.

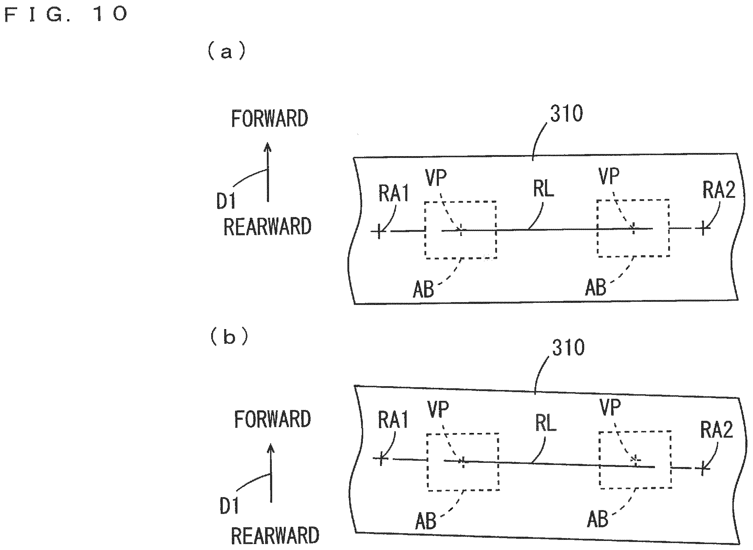

Fig. 10(a) shows one example of the positional relationship between the fields-of-view AB of the cameras 21, 22 and the reference line RL of the transfer roller 310 when the table device 200 is in the lower end opposing position. Fig. 10(b) shows another example of the positional relationship between the fields-of-view AB of the cameras 21, 22 and the reference line RL of the transfer roller 310 when the table device 200 is in the lower end opposing position. Each of Figs. 10(a) and 10(b) shows the outer peripheral surface of the transfer roller 310 as viewed from below. In the present embodiment, the length of the reference line RL provided on the outer peripheral surface of the transfer roller 310 is longer than the distance between the two alignment marks M11, M12 on the calibration plate CP of Fig. 4.

The user adjusts the position of the table device 200 in the front-and-rear direction D1 while viewing the image displayed in the display 7 such that the reference index VP of the one camera 21 out of the two cameras 21, 21 is positioned on the reference line RL, for example. In this case, the two reference indices VP of the two cameras 21, 22 are arranged in the left-and-right direction D2. Therefore, when the axial center of the transfer roller 310 is parallel to the plane orthogonal to the front-and-rear direction D1, both of the two reference indices VP of the cameras 21, 22 are positioned on the reference line RL as shown in Fig. 10(a). In contrast, in the case where the axial center of the transfer roller 310 is inclined with respect to the plane orthogonal to the front-and-rear direction D1, even when the reference index VP of the one camera 21 is positioned on the reference line RL, the reference index VP of the other camera 22 deviates from the reference line RL as shown in Fig. 10(b).

As such, the user moves the support position of the other end of the rotation shaft 320 in the front-and-rear direction D1 by the rotation shaft adjustment mechanism 340 such that both of the two reference indices VP of the cameras 21, 22 are positioned on the reference line RL. That is, the orientation of the rotation shaft 320 of the transfer roller 310 is adjusted in the plane parallel to the support surface 201a. Alternatively, the user moves the support position of the other end of the rotation shaft 320 in the front-and-rear direction D1 by the rotation shaft adjustment mechanism 340 such that the respective distances from the reference line RL to the respective reference indices VP of the cameras 21, 22 in the front-and-rear direction D1 are equal to each other on the respective images acquired by the cameras 21, 22. Thus, the axial center of the transfer roller 310 becomes parallel to the plane orthogonal to the front-and-rear direction D1.

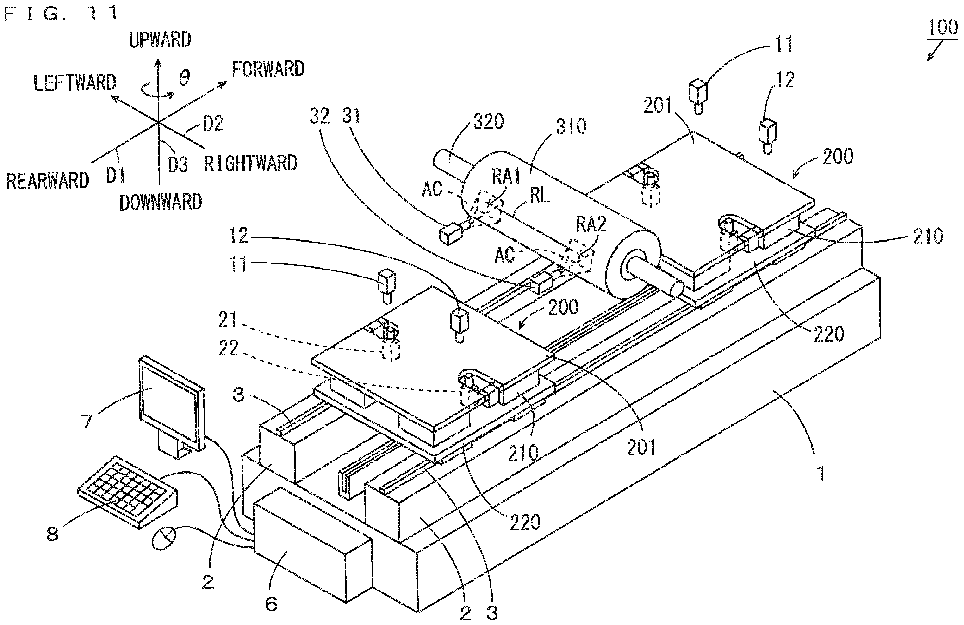

Next, as shown in Fig. 11, the rear table device 200 is moved to the table reference position. Further, the transfer roller 310 is rotated from the reference angle to a predetermined rotation angle such that the alignment marks RA1, RA2 and the reference line RL are directed in a predetermined direction. The predetermined rotation angle of the transfer roller 310 at the time is referred to as an imaging angle. In the present example, with the transfer roller 310 at the imaging angle, the alignment marks RA1, RA2 and the reference line RL are directed rearward.

In this state, the images acquired by the cameras 31, 32 are displayed in the display 7. The user positions the camera 31 while viewing the image displayed in the display 7 such that the reference index VP (Fig. 5) of the camera 31 is positioned on the alignment mark RA1 of the transfer roller 310. Further, the user positions the camera 32 such that the reference index VP (Fig. 5) of the camera 32 is positioned on the alignment mark RA2 of the transfer roller 310. Thus, when the axial center of the transfer roller 310 is parallel to the second direction, the two reference indices VP of the two cameras 31, 32 are accurately arranged in the left-and-right direction D2. Thus, calibration for enabling the accurate transfer between the rear table device 200 and the transfer roller 310 is completed.

When the front table device 200 is used, a positioning operation of the cameras 11, 12 provided at positions farther forward than the transfer roller 310 is also performed for the front table device 200 similarly to the above-mentioned steps shown in Figs. 1, 6, 7 and 8. Further, a positioning operation of the cameras 21, 22 provided at the front table device 200 is performed. Thus, calibration for enabling the accurate transfer between the front table device 200 and the transfer roller 310 is completed.

The above-mentioned calibration is carried out every predetermined number of times the transfer is performed, every day or every change operation of a sheet-like member SM, described below.

### (2) Transfer

In the present embodiment, a transfer article to be transferred to an object is held by the sheet-like member configured to be attachable to and detachable from the transfer roller 310, for example. Here, the sheet-like member has an attachment surface to be attached to the outer peripheral surface of the transfer roller 310 and a holding surface provided on the opposite side to the attachment surface. The holding surface is configured to be able to hold the transfer article.

When the transfer article is conductive ink such as nano-silver ink, the shape of the holding surface of the sheet-like member is selected from a flat surface or an irregular surface according to the specification of the transfer article.

When the transfer article is an electronic component such as a predetermined element or a chip on which a predetermined element is mounted, it is necessary that at least a partial region on the holding surface of the sheet-like member is adhesive. In this case, the entire holding surface of the sheet-like member may be an adhesive region, or part of the holding surface of the sheet-like member may be an adhesive region. Further, in this case, the holding surface of the sheet-like member may be a flat surface or an irregular surface.

When the transfer is performed, the sheet-like member for holding the above-mentioned transfer article is attached to the outer peripheral surface of the transfer roller 310. The sheet-like member is made of a flexible resin base material, for example. The sheet-like member is provided with two alignment marks respectively corresponding to the two alignment marks RA1, RA2 of the transfer roller 310.

Here, in the outer peripheral surface of the transfer roller 310, the portion to which the sheet-like member is to be attached is predetermined as a sheet attachment portion. When the sheet-like member is accurately attached to the sheet attachment portion, the two alignment marks of the sheet-like member respectively overlap with the two alignment marks RA1, RA2 of the transfer roller 310. On the other hand, when the sheet-like member is attached to a position deviating from the sheet attachment portion, at least one of the two alignment marks of the sheet-like member deviates from the corresponding alignment mark of the transfer roller 310.

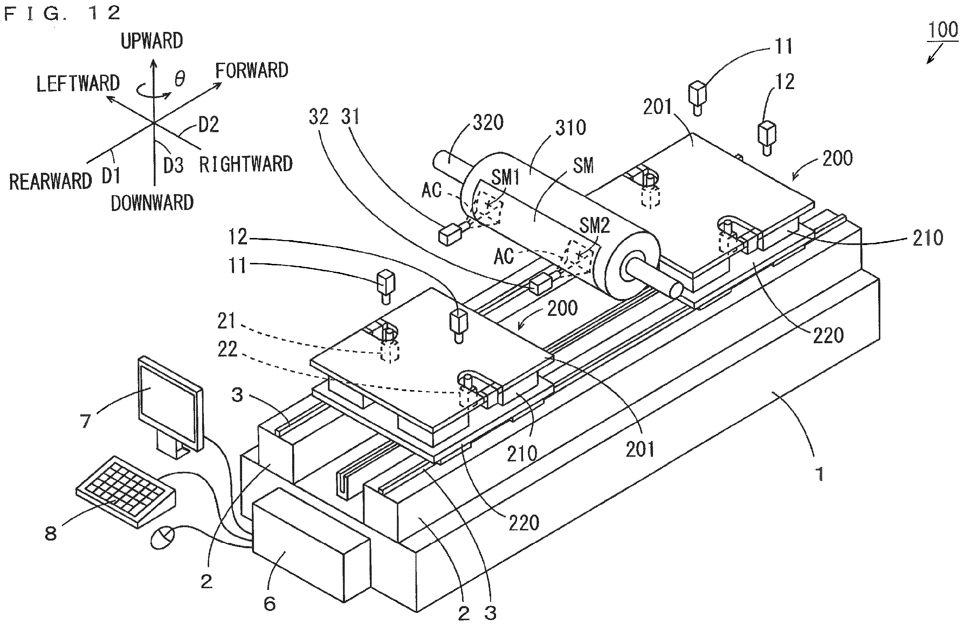

Fig. 12 is an external perspective view of the transfer device 100 showing the steps for detecting a position deviation of the sheet-like member attached to the transfer roller 310. In Fig. 12, part of constituent elements of the transfer device 100 is not shown.

As shown in Fig. 12, the user attaches the sheet-like member SM to the sheet attachment portion of the transfer roller 310, and then adjusts the rotation angle of the transfer roller 310 to the imaging angle. In this state, the images acquired by the cameras 31, 32 are displayed in the display 7.

As described above, the reference indices VP of the two cameras 31, 32 are respectively positioned on the two alignment marks RA1, RA2 (Fig. 11) formed on the outer peripheral surface of the transfer roller 310. Therefore, when the sheet-like member SM is accurately attached to the sheet attachment portion, the reference indices VP of the two cameras 31, 32 are respectively positioned on the two alignment marks SM1, SM2 of the sheet-like member.

On the other hand, when the sheet-like member SM is attached to a position deviating from the sheet attachment portion, at least one of the reference indices VP of the two cameras 31, 32 deviates from corresponding one of the two alignment marks SM1, SM2 of the sheet-like member. In this case, an amount of deviation of the alignment mark SM1 from the reference index VP of the camera 31, which means that an amount of deviation of the alignment mark SM1 from the alignment mark RA1 (Fig. 11) can be calculated based on the image acquired from the camera 31. Further, an amount of deviation of the alignment mark SM2 from the reference index VP of the camera 32, that is, an amount of deviation of the alignment mark SM2 from the alignment mark RA2 (Fig. 11) can be calculated based on the image acquired by the camera 32.

As such, the user allows the controller 6 of Fig. 3 to calculate an amount of deviation of the alignment mark SM1 from the alignment mark RA1 and an amount of deviation of the alignment mark SM2 from the alignment mark RA2 based on the images displayed in the display 7 by operating the operation unit 8. The user records the calculated amounts of deviation.

As an object to which a transfer article is transferred, a semiconductor substrate, a glass substrate or a flexible resin base material is used. The object has the same outer shape as the calibration plate CP of Fig. 4. Further, two alignment marks are provided at positions of the object respectively corresponding to the two alignment marks M11, M12 of the calibration plate CP of Fig. 4.

After the sheet-like member SM is attached to the transfer roller 310, the rear table device 200 is moved to the table reference position. The object is arranged on the table 201 such that the two alignment marks of the object are positioned in the fields-of-view AA of the cameras 11, 12 (Fig. 2) with the table device 200 in the table reference position.

In this state, the images acquired by the cameras 11, 12 are displayed in the display 7. The user adjusts a position in the front-and-rear direction D1, a position in the left-and-right direction D2 and an rotation angle in the θ direction of the table 201 with respect to the transfer base 220B (Fig. 2) such that the reference indices VP of the cameras 11, 12 are positioned on the two alignment marks of the object. Thus, the two alignment marks of the object are arranged in the left-and-right direction D2.

Next, the user corrects the position in the front-and-rear direction D1, the position in the left-and-right direction D2 and the rotation angle in the θ direction of the table 201 with respect to the transfer base 220B (Fig. 2) such that the amount of deviation calculated by the controller 6 during calibration is offset when the transfer article is transferred to the object.

For example, when the alignment marks SM1, SM2 of the sheet-like member SM deviate leftward by 5 µm from the two alignment marks RA1, RA2 of the transfer roller 310, respectively, the table 201 on the transfer base 220B (Fig. 2) is moved leftward by 5 µm. Further, when the alignment marks SM1, SM2 of the sheet-like member SM are advanced by 5 µm from the two alignment marks RA1, RA2 of the transfer roller 310 in the rotation direction of the transfer roller 310, the table 201 on the movement driver 220 is moved forward by 5 µm.

Thereafter, the rear table device 200 is moved forward to pass below the transfer roller 310, and the transfer roller 310 is rotated. At this time, part of the sheet-like member SM comes into contact with the upper surface of the object, whereby the transfer article held by the sheet-like member SM is transferred onto the object.

In the above-mentioned transfer device 100, the transfer article can be transferred to the object using two plates. In the following description, the two plates are respectively referred to as a first plate and a second plate. In this case, the adhesive first plate is attached to the transfer roller 310 as the sheet-like member SM during the above-mentioned calibration. Further, the second plate holding the transfer article having a predetermined pattern is arranged on the rear table device 200. Further, the object is arranged on the front table device 200.

The rear table device 200 is moved in the front-and-rear direction D1, and the transfer roller 310 is rotated, whereby the transfer article held by the second plate is transferred to the first plate. Therefore, the front table device 200 is moved in the front-and-rear direction D1, and the transfer roller 310 is rotated, whereby the transfer article held by the first plate is transferred to the object.

When the transfer article is transferred to the object using the first and second plates, the above-mentioned alignment marks SM1, SM2 are provided on the first plate. Further, the second plate is provided with two alignment marks corresponding to the two alignment marks M11 and M12 of the calibration plate CP. Thus, the positional relationship among the first plate, the second plate and the object can be corrected in the steps similar to the above-mentioned example.

### (3) Correction During Transfer

In the above-mentioned transfer device 100, when the transfer is repeatedly performed, an amount of deviation (hereinafter referred to as a transfer deviation amount) of a transfer position to which a transfer article is actually transferred from a design position to which the transfer article is to be transferred is detected by the controller 6 every lot or every predetermined number (100 times, for example) of times the transfer is performed.

The controller 6 calculates an amount of correction of the position in the front-and-rear direction D1, the position in the left-and-right direction D2 and the rotation angle in the θ direction of the table 201with respect to the transfer base 220B (Fig. 2) such that the detected transfer deviation amount is offset when the detected transfer deviation amount exceeds a predetermined allowable range, and stores the amount of correction. Further, the controller 6 makes correction when the transfer is to be performed to a next transfer-receiving object based on the stored amount of correction. In the case where a new amount of correction is calculated when an amount of correction is stored in advance, the controller 6 updates the pre-stored amount of correction with the new amount of correction.

Further, when the amount of correction is first stored or when the amount of correction is updated, the controller 6 detects a transfer deviation amount, calculates an amount of correction and makes correction again for a next transfer-receiving object. In this manner, detection of a transfer deviation amount and correction of a position of the table 201are repeated until the detected transfer deviation amount is within the allowable range. Thus, an increase in measurement error that occurs over time due to continuous use of the transfer device 100 is reduced.

When accuracy of positioning (a margin of error) the table 201by the table supporter 210 is set to a specific value or less, the above-mentioned allowable range is preferably set to the specific value or less, and is more preferably set to 80 % of the specific value or less. For example, when the accuracy of positioning the table 201is set to 2 µm or less, the allowable range is preferably set to not more than ± 2 µm, and is more preferably set to not more than ± 1.6 µm.

The transfer deviation amount can be detected as described below. For example, when conductive ink is used as a transfer article, the sheet-like member is allowed to hold a pattern of conductive ink and a first detection mark made from conductive ink. Further, a second detection mark corresponding to the first detection mark is formed in advance at a position on an object to which the first detection mark is to be transferred.

In this case, when the pattern is transferred to the position to which the pattern is to be transferred on the object, the first detection mark accurately overlaps with the second detection mark. On the other hand, when the pattern is transferred to the position deviating from the position to which the pattern is to be transferred on the object, the first detection mark is transferred to the position deviating from the second detection mark.

The amount of deviation between the first and second detection marks can be calculated based on the image data acquired when the first and second detection marks are imaged by a camera after the transfer. The calculated value is the transfer deviation amount.

In addition to the above-mentioned example, when a plurality of chips are used as transfer articles, a third detection mark corresponding to a specific chip may be formed at the position to which the specific chip out of the plurality of chips is to be transferred on the object. Thus, the specific chip and the third detection mark are imaged by the camera after the transfer, whereby an amount of deviation between the specific chip and the third detection mark can be calculated as the transfer deviation amount.

### [3] Effect

In the transfer device 100 according to the present embodiment, calibration is carried out before the transfer article is transferred to the object. With the above-mentioned steps of calibration, the calibration plate CP is positioned on the table 201 such that the one direction and the other direction of the calibration plate CP placed on the table device 200 are respectively parallel to the front-and-rear direction D1 and the left-and-right direction D2. Further, the two reference indices VP of the two cameras 21, 22 provided at each table device 200 are adjusted to be accurately arranged in the left-and-right direction D2.

Thereafter, the two cameras 21, 22 are moved to the lower end opposing position together with the table device 200. Thus, the orientation of the rotation shaft 320 of the transfer roller 310 is adjusted in the plane parallel to the support surface 201a based on the two reference indices VP of the two cameras 21, 22 and the reference line RL provided at the transfer roller 310. Thus, the reference line RL of the transfer roller 310 is parallel to the plane orthogonal to the front-and-rear direction D1. Therefore, the deviation of the rotation shaft 320 of the transfer roller 310 caused by an error in an assembly of the plurality of constituent elements of the transfer device 100 is reduced. As a result, the transfer article can be transferred to the desired position of the object with high accuracy.

Further, in the present embodiment, based on the results of detection of the height of the lower end of the outer peripheral surface of the transfer roller 310 by the laser displacement sensors 91, 92, the axial center of the transfer roller 310 can be adjusted to be parallel to the support surface 201a. Therefore, the transfer article can be transferred to the desired position of the object with higher accuracy.

### [4] Other Embodiments

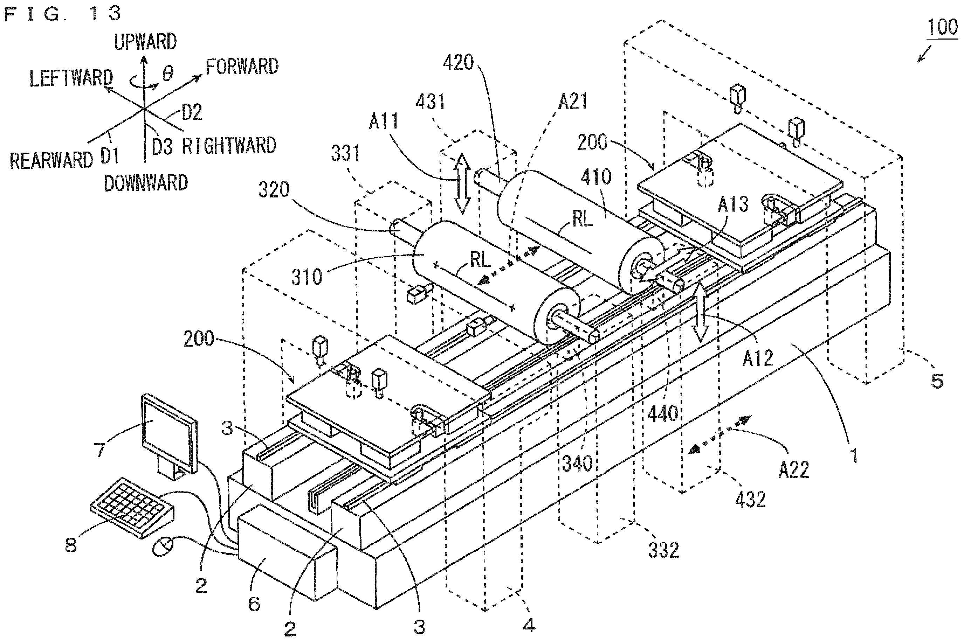

(1) While the user determines the lower end opposing position based on the results of detection of the distance (height) by the laser displacement sensors 91, 92 and records the determined lower end opposing position in the above-mentioned embodiment, the present invention is not limited to this. In the transfer device 100, the controller 6 may determine the lower end opposing position based on the results of detection of the distance (height) by the laser displacement sensors 91, 92, and may store the determined lower end opposing position.
(2) In the above-mentioned embodiment, the user arranges one of the object, the plate and the calibration plate CP on the table 201, and the user removes one of the object, the plate and the calibration plate CP supported on the table 201. However, the present invention is not limited to this. The transfer device 100 may have an arrangement device that can be controlled by the controller 6 and can transfer one of the object, the plate and the calibration plate CP. In this case, the controller 6 may automatically arrange one of the object, the plate and the calibration plate CP at the table device 200 by controlling the arrangement device. Further, the controller 6 may automatically remove one of the object, the plate, the calibration plate CP from the table device 200 by controlling the arrangement device.
(3) While the user manually performs the positioning operation of the cameras 11, 12, 21, 22, 31, 32 in the above-mentioned embodiment, the present invention is not limited to this. The transfer device 100 may have a camera adjustment device that can be controlled by the controller 6 and can adjust the positions and orientations of the cameras 11, 12, 21, 22, 31, 32. In this case, the controller 6 may automatically perform the positioning operation of the cameras 11, 12, 21, 22, 31, 32 by controlling the camera adjustment device based on the images acquired by the cameras 11, 12, 21, 22, 31, 32, for example.
(4) While the user attaches the sheet-like member to the outer peripheral surface of the transfer roller 310 in the above-mentioned embodiment, the present invention is not limited to this. The transfer device 100 may have an attachment detachment device that can be controlled by the control device 6, attach the sheet-like member to and detach the sheet-like member from the outer peripheral surface of the transfer roller 310. In this case, the controller 6 may automatically attach the sheet-like member to the outer peripheral surface of the transfer roller 310 by controlling the attachment detachment device. Further, the controller 6 may automatically detach the sheet-like member from the outer peripheral surface of the transfer roller 310 by controlling the attachment detachment device.
(5) While the user moves the support position of the other end of the rotation shaft 320 in the front-and-rear direction D1 by the rotation shaft adjustment mechanism 340 in the above-mentioned embodiment, the present invention is not limited to this. The rotation shaft adjustment mechanism 340 may be configured to be controllable by the controller 6. In this case, the controller 6 may adjust the support position of the other end of the rotation shaft 320 of the transfer roller 310 based on the images acquired by the cameras 21, 22 such that both of the two reference indices VP of the cameras 21, 22 are positioned on the reference line RL.
(6) When the transfer device 100 is provided with the above-mentioned arrangement device, camera adjustment device and attachment detachment device, and the rotation shaft adjustment mechanism 340 is configured to be controllable by the controller 6, part or all of the above-mentioned calibration may be automatically carried out by the controller 6.
(7) While the calibration plate CP is constituted by the transparent portion CP1 and the frame portion CP2 in the above-mentioned embodiment, the present invention is not limited to this. The calibration plate CP may be formed of only the transparent portion CP1. In this case, the transparent portion CP1 is formed to have the same outer shape as the object.
(8) While the CCD camera having the objective lens with fixed magnification is used as each of the cameras 11, 12, 21, 22, 31, 32 in the above-mentioned embodiment, the present invention is not limited to this. A CCD camera having a zoom lens with changeable magnification may be used as each of the cameras 11, 12, 21, 22, 31, 32.
   In this case, when the alignment mark M1 of the calibration plate CP is searched using the camera 11, for example, the magnification of the zoom lens is set low. Thus, the subject alignment mark M1 can be easily searched over a wide range. On the other hand, when the camera 11 is positioned, the magnification of the zoom lens is set high. Thus, the image of the subject alignment mark M1 can be acquired at high resolution. Thus, the camera 11 can be positioned with high accuracy.
   In this manner, when the CCD camera having the zoom lens is used as each of the cameras 11, 12, 21, 22, 31, 32, the above-mentioned calibration can be easily and more accurately carried out.
   The CCD camera having a plurality of objective lenses with different magnification may be used as each of the cameras 11, 12, 21, 22, 31, 32. In this case, the objective lenses of the cameras 11, 12, 21, 22, 31, 32 are respectively used according to the respective contents of the calibration, whereby the above-mentioned calibration can be easily and more accurately carried out.
(9) In the above-mentioned embodiment, the two alignment marks M1, M2 are used to make the one direction of the calibration plate CP be parallel to the front-and-rear direction D1, and the alignment marks M11, M12 are used to make the reference indices VP of the cameras 11, 12 be arranged in the left-and-right direction D2. However, the present invention is not limited to this. The two alignment marks M1, M11 may be used to make the one direction of the calibration plate CP be parallel to the front-and-rear direction D1, and the alignment marks M11, M12 may be used to make the reference indices VP of the cameras 11, 12 be arranged in the left-and-right direction D2. That is, the one alignment mark M11 may be used as the first or second alignment mark in order to make the one direction of the calibration plate CP be parallel to the front-and-rear direction D1, and may also be used as the third and fourth alignment marks in order to make the reference indices VP of the two cameras 11, 12 be arranged in the left-and-right direction D2.
(10) While the two alignment marks M1, M2 for making the one direction of the calibration plate CP be parallel to the front-and-rear direction D1 and the alignment mark M11 for making the reference indices VP of the cameras 11, 12 be arranged in the left-and-right direction D2 are arranged in the one direction in the calibration plate CP in the above-mentioned embodiment, the present invention is not limited to this. The alignment mark M11 may be provided at a position deviating from the direction in which the two alignment marks M1, M2 are arranged.
(11) While the transfer device 100 has the one transfer roller 310 in the above-mentioned embodiment, the present invention is not limited to this. The transfer device 100 may have a plurality of transfer rollers. Fig. 13 is an external perspective view of a transfer device 100 for an electronic device according to another embodiment. As for the transfer device 100 of Fig. 13, differences from the transfer device 100 of Fig. 1 will be described below.

In the transfer device 100 of Fig. 13, in addition to the configuration of the transfer device 100 of Fig. 1, a roller support device 431 is provided at a position farther forward than the roller support device 331 and farther rearward than the second main body 5. Further, a roller support device 432 is provided at a position farther forward than the roller support device 332 and farther rearward than the second main body 5. A transfer roller 410 is provided between the roller support devices 431, 432. The transfer roller 410 has a rotation shaft 420 and has an outer peripheral surface that can hold a transfer article. A reference line RL extending in parallel to the rotation shaft 420 is provided at part of the outer peripheral surface of the transfer roller 410.

The roller support devices 431, 432 basically have the same configuration as the roller support devices 331, 332, and respectively rotatably support one end and the other end of the rotation shaft 420 of the transfer roller 410. Further, each of the roller support devices 431, 432 has a lift-lower driver and a rotation driver (not shown).

The lift-lower driver of each of the roller support devices 431, 432 rotatably supports each end of the rotation shaft 420, and moves a support position of each end in the up-and-down direction D3 as indicated by the outlined arrows A11, A12 in Fig. 13. The rotation driver of each of the roller support devices 431, 432 rotates the transfer roller 410. These lift-lower drivers and the rotation drivers are controlled by the controller 6.

The roller support device 432 is provided with a rotation shaft adjustment mechanism 440 configured to be operable by the user. As indicated by the outlined arrow A13 in Fig. 13, the rotation shaft adjustment mechanism 440 can move the support position of the other end of the rotation shaft 320 supported by the roller support device 432 in the front-and-rear direction D1.

Each of the roller support devices 431, 432 further has an advance-retreat driver (not shown). As indicated by the thick dotted arrow A21, the advance-retreat driver of the roller support device 431 moves the one end of the rotation shaft 420 in the front-and-rear direction D1 with respect to the roller support device 331.

As indicated by the thick dotted arrow A22, the advance-retreat driver of the roller support device 432 moves the other end of the rotation shaft 420 in the front-and-rear direction D1 with respect to the roller support device 331. These advance-retreat drivers are controlled by the controller 6.

When the calibration of the transfer device 100 of Fig. 13 is carried out, the axial center of the transfer roller 410 is made parallel to the support surface 201a (Fig. 2) in the steps similar to the steps of the calibration of the above-mentioned transfer roller 310. Further, the axial center of the transfer roller 410 is made parallel to the plane orthogonal to the front-and-rear direction D1. Thus, even when the transfer is performed using the two transfer rollers 310, 410, the transfer article can be transferred to a desired position of an object with high accuracy.

An example of use of the transfer device 100 of Fig. 13 will be described. In the following description, a transfer article is a chip having one surface and another surface. The chip is provided such that the one surface comes into contact with the upper surface of one substrate (hereinafter referred to as a first substrate). This chip is transferred such that the other surface comes into contact with the upper surface of a new substrate (a second substrate).

In this case, a first sheet-like member is attached to the outer peripheral surface of a transfer roller 310, and a second sheet-like member is attached to the outer peripheral surface of a transfer roller 410. Further, the first substrate is positioned by being placed on the rear table device 200 with the other surface of the chip directed upward. Further, the second substrate is positioned by being placed on the front table device 200. The holding surface of the first sheet-like member, the holding surface of the second sheet-like member and the upper surface of the second substrate are adhesive.

In this state, the rear table device 200 is moved, and the transfer roller 310 is rotated. Thus, the chip is transferred from the first substrate to the first sheet-like member such that the other surface comes into contact with the holding surface of the first sheet-like member.

Next, the transfer roller 410 is moved rearward to come into contact with the outer peripheral surface of the transfer roller 310, and the transfer rollers 310, 410 are rotated in opposite directions to each other. Thus, the chip is transferred from the first sheet-like member to the second sheet-like member such that the one surface comes into contact with the holding surface of the second sheet-like member.

Thereafter, the front table device 200 is moved, and the transfer roller 410 is rotated. Thus, the chip is transferred from the second sheet-like member to the second substrate such that the other surface comes into contact with the upper surface of the second substrate. Such a transfer operation is performed, so that the state of the chip that is placed on the second substrate is reverse of the state of the chip placed on the first substrate.

In addition to the example of Fig. 13, the transfer device 100 may have three or more transfer rollers. In this case, a plurality of different types of transfer articles are held by a plurality of transfer rollers, for example. Thus, one substrate is sequentially brought into contact with a plurality of transfer rollers, whereby the plurality of transfer articles can be continuously transferred onto the substrate. The plurality of types of transfer articles include a chip including a red light-emitting element, a chip including a green light-emitting element and a chip including a blue light-emitting element, for example. Alternatively, the plurality of types of transfer articles include a red filter, a green filter or a blue filter.

Here, when the chip is provided such that the one surface comes into contact with the upper surface of the first substrate, transferring the chip such that the other surface comes into contact with the upper surface of the second substrate is referred to as reverse transfer. When the reverse transfer is performed, the chip is transferred onto the second substrate from the first substrate via the two transfer rollers as described above. On the other hand, when the chip is provided such that the one surface comes into contact with the upper surface of the first substrate, transferring the chip such that the one surface comes into contact with the upper surface of the second substrate is referred to as normal transfer. When the normal transfer is performed, the chip is transferred onto the second substrate from the first substrate via one transfer roller.

Whether the reverse transfer or the normal transfer is to be performed is determined according to the specification of the chip. When a plurality of types of chips are transferred onto one substrate using the transfer device 100 having a plurality of transfer rollers, a transfer roller to be used for the reverse transfer and a transfer roller to be used for the normal transfer can be set for each chip.

In this case, the normal transfer can be continuously performed a plurality of times, the reverse transfer can be continuously performed a plurality of times, and the normal transfer and the reverse transfer can be performed in combination with each other. As a result, the transfer can be performed desirably regardless of the specification of a chip, and the convenience of the transfer device 100 is improved.

### Correspondences between Constituent Elements in Claims and Parts in Preferred Embodiments

In the following paragraphs, non-limiting examples of correspondences between various elements recited in the claims below and those described above with respect to various preferred embodiments of the present invention are explained.

In the above-mentioned embodiment, the alignment mark M1 is an example of a first alignment mark, the alignment mark M2 is an example of a second alignment mark, the alignment mark M11 is an example of a third alignment mark, the alignment mark M12 is an example of a fourth alignment mark, the calibration plate CP is an example of a calibration plate, and the transfer device 100 is an example of a transfer device for an electronic device.

Further, the support surface 201a is an example of a support surface, the table 201 is an example of a table, the front-and-rear direction D1 is an example of a first direction, the left-and-right direction D2 is an example of a second direction, the table supporter 210 is an example of a table supporter, the initial position is an example of a first position, the separation position is an example of a second position, the table reference position is an example of a third position, the lower end opposing position is an example of a fourth position, and the movement driver 220 is an example of a movement driver.

Further, the rotation shaft 320 is an example of a rotation shaft, the reference line RL is an example of a reference line, the transfer rollers 310, 410 are examples of a transfer roller, the lift-lower drivers 341 of the roller support devices 331, 332 and the lift-lower drivers of the roller support devices 431, 432 are examples of a shaft supporter, the rotation drivers 351 of the roller support devices 331, 332 and the rotation drivers of the roller support devices 431, 432 are examples of a rotation driver, the reference index VP of the camera 11 is an example of a first reference index, the camera 11 is an example of a first imager, the reference index VP of the camera 12 is an example of a second reference index, the camera 12 is an example of a second imager, the reference index VP of the camera 21 is an example of a third reference index, the camera 21 is an example of a third imager, the reference index VP of the camera 22 is an example of a fourth reference index, the camera 22 is an example of a fourth imager, and the display 7 is an example of a display.

Further, the laser displacement sensor 91 and the controller 6 are examples of a first detector, the height reference position set for the laser displacement sensor 91 is an example of a first detection position, the laser displacement sensor 92 and the controller 6 are examples of a second detector, and the height reference position set for the laser displacement sensor 92 is an example of a second detection position.

Further, the sheet-like member SM is an example of a sheet-like member, the alignment mark SM1 is an example of a fifth alignment mark, the alignment mark SM2 is an example of a sixth alignment mark, the alignment mark RA1 is an example of a seventh alignment mark, the alignment mark RA2 is an example of an eighth alignment mark, the reference index VP of the camera 31 is an example of a fifth reference index, the camera 31 is an example of a fifth imager, the reference index VP of the camera 32 is an example of a sixth reference index, and the camera 32 is an example of a sixth imager.

As each of constituent elements recited in the claims, various other elements having configurations or functions described in the claims can be also used.

### [Industrial Applicability]

The present invention can be effectively utilized for manufacture of electronic devices.

## Claims

1. A transfer device (100) for an electronic device, the transfer device (100) being able to carry out calibration using a calibration plate (CP) having first and second alignment marks (M1 and M2) arranged in a first direction (D1) and third and fourth alignment marks (M11 and M12) arranged in a second direction (D2) orthogonal to the first direction (D1), and transferring a transfer article, said transfer article comprising part or all of functional materials that constitute the electronic device or part or all of electronic components that constitute the electronic device, to an object, said transfer device (100) comprising:
a table (201) having a support surface (201a) that selectively supports the calibration plate (CP) and the object;
a table supporter (210) that supports the table (201) such that the table (201) is movable in the first and second directions (D1 and D2) that are parallel to the support surface (201a) and orthogonal to each other, and supports the table (201) such that the table (201) is rotatable about an axis orthogonal to the support surface (201a);
a movement driver (220) that moves the table supporter (210) in the first direction (D1) among a first, a second, a third and a fourth position;
a transfer roller (310; 410) that has a rotation shaft (320; 420) and an outer peripheral surface that holds the transfer article and includes a reference line (RL) parallel to the rotation shaft (320; 420);
a shaft supporter (341) that supports the transfer roller (310; 410) such that the transfer roller (310; 410) is rotatable about the rotation shaft (320; 420);
a rotation driver (351) that rotates the transfer roller (310; 410);
a first imager (11) that has a field-of-view (AA) including a first reference index (VP) and is configured to : - image the first alignment mark (M1) when the table supporter (210) is in the first position with the calibration plate (CP) supported by the table (201), - image the second alignment mark (M2) when the table supporter (210) is in the second position with the calibration plate (CP) supported by the table (201), and - image the third alignment mark (M11) when the table (201) supporting the calibration plate (CP) is in the third position;
a second imager (12) that has a field-of-view (AA) including a second reference index (VP) and is configured to image the fourth alignment mark (M12) when the table supporter (210) is in the third position with the calibration plate (CP) supported by the table (201);
a third imager (21) that has a field-of-view (AB) moving together with the table supporter (210) and including a third reference index (VP) and is configured to image the third alignment mark (M11) of the calibration plate (CP) when the table supporter (210) is in the third position with the calibration plate (CP) supported by the table (201), and to image the reference line (RL) of the transfer roller (310; 410) when the table supporter (210) is in the fourth position; and
a fourth imager (22) that has a field-of-view (AB) moving together with the table supporter (210) and including a fourth reference index (VP) and is configured to image the fourth alignment mark (M12) of the calibration plate (CP) when the table supporter (210) is in the third position with the calibration plate (CP) supported by the table (201), and to image the reference line (RL) of the transfer roller (310; 410) when the table supporter (210) is in the fourth position; and
a display (7) that displays images imaged by the first, second, third and fourth imagers (11, 12, 21, 22), wherein
the first and second imagers (11, 12) are provided such that the position of the first and second imager (11, 12) are adjustable independently from the table supporter (210), the third and fourth imagers (21, 22) are provided such that the positions of the third and fourth imagers (21, 22) are adjustable relative to the table (201), and the transfer roller (310; 410) is provided such that an orientation of the rotation shaft (320; 420) of the transfer roller (310; 410) is adjustable at least in a plane parallel to the support surface (201a).

2. The transfer device (100) for the electronic device according to claim 1, further comprising:
a first detector (91) that moves together with the table supporter (210) and is configured to detect a distance from a first detection position to the outer peripheral surface of the transfer roller (310; 410); and
a second detector (92) that moves together with the table supporter (210) and is configured to detect a distance from a second detection position to the outer peripheral surface of the transfer roller (310; 410), wherein
the first detection position and the second detection position are positioned on a common line extending in the second direction (D2) to be separated from each other, and
the transfer roller (310; 410) is further provided such that an orientation of the rotation shaft (320; 420) is adjustable in a plane parallel to the second direction (D2) and a third direction (D3) that is orthogonal to the support surface (201a).

3. The transfer device (100) for the electronic device according to claims 1 or 2, wherein
the transfer article is held by a sheet-like member (SM) configured to be attachable to and detachable from the transfer roller (310; 410),
the sheet-like member (SM) has fifth and sixth alignment marks (SM1 and SM2), the
outer peripheral surface of the transfer roller (310; 410) includes seventh and eighth alignment marks (RA1 and RA2) arranged in a direction parallel to the rotation shaft (320; 420),
the transfer device (100) further includes
a fifth imager (31) that has a field-of-view (AC) including a fifth reference index (VP) and is configured to image the seventh alignment mark (RA1) when the transfer roller (310; 410) is at a predetermined rotation angle with the sheet-like member (SM) not attached to the transfer roller (310; 410), and to image the fifth alignment mark (SM1) when the transfer roller (310; 410) is at the predetermined rotation angle with the sheet-like member (SM) attached to the transfer roller (310; 410), and to image the sixth imager (32) that has a field-of-view (AC) including a sixth reference index (VP) and is configured to image the eighth alignment mark (RA2) when the transfer roller (310; 410) is at the predetermined rotation angle with the sheet-like member (SM) not attached to the transfer roller (310; 410), and to image the sixth alignment mark (SM2) when the transfer roller (310; 410) is at the predetermined rotation angle with the sheet-like member (SM) attached to the transfer roller (310; 410),
the display (7) further displays images that are imaged by the fifth and sixth imagers (31, 32), and
the fifth and sixth imagers (31, 32) are provided such that the positions of the fifth and sixth imagers (31, 32) are adjustable independently from the transfer roller (310; 410).

4. The transfer device (100) for the electronic device according to any one of claims 1 to 3, having a plurality of the transfer rollers (310, 410), wherein
the shaft supporter (341) is configured to rotatably support each of the plurality of transfer rollers (31; 410),
the rotation driver (351) is configured to respectively rotate the plurality of transfer rollers (310, 410), and
the fourth position is set as each of a plurality of positions respectively corresponding to the plurality of transfer rollers (310, 410).

5. A transfer method for an electronic device, including the steps of:
preparing the transfer device (100) for the electronic device according to any one of claims 1 to 4;
calibrating the transfer device (100); and
transferring a transfer article to an object using the calibrated transfer device (100), wherein
the calibrating includes the steps of
arranging the calibration plate (CP) on the support surface of the table (201a),
moving the table supporter (210) to the first position and displaying an image of the first alignment mark (M1) imaged by the first imager (11) in the display (7) with the calibration plate (CP) supported by the table (201),
adjusting a position of the first imager(ll) such that the first reference index (VP) of the first imager (11) is positioned on the first alignment mark (M1) when the table supporter (210) is in the first position with the calibration plate (CP) supported by the table (201),
moving the table supporter (210) to the second position and displaying an image of the second alignment mark (M2) that is imaged by the first imager (11) in the display (7) with the calibration plate (CP) supported by the table (201) after the adjusting the position of the first imager (11),
adjusting a position of the table (201) supporting the calibration plate (CP) by the table supporter (210) such that the first reference index (VP) of the first imager (11) is positioned on the first alignment mark (M1) when the table supporter (210) is in the first position with the calibration plate (CP) supported by the table (201), and adjusting the position of the table (201) supporting the calibration plate (CP) by the table supporter (210) such that the first reference index (VP) of the first imager (11) is positioned on the second alignment mark (M2) when the table supporter (210) is in the second position with the calibration plate (CP) supported by the table (201), after the adjusting the position of the first imager (11);
moving the table supporter (210) to the third position and displaying an image of the third alignment mark (M11) that is imaged by the first imager (11), an image of the fourth alignment mark (M12) that is imaged by the second imager (12), an image of the third alignment mark (M11) that is imaged by the third imager (21), and an image of the fourth alignment mark (M4) that is imaged by the fourth imager (22) with the calibration plate (CP) supported by the table (201) after the adjusting the position of the table (201),
adjusting a position of the first imager (11) such that the first reference index (VP) of the first imager (11) is positioned on the third alignment mark (M11), adjusting a position of the second imager (12) such that the second reference index (VP) of the second imager (12) is positioned on the fourth alignment mark (M12), adjusting a relative positional relationship between the third imager (21) and the table (201) such that the third reference index (VP) of the third imager (21) is positioned on the third alignment mark (M11), and adjusting a relative positional relationship between the fourth imager (22) and the table (201) such that the fourth reference index (VP) of the fourth imager (22) is positioned on the fourth alignment mark (M12), after displaying the images of the first to fourth alignment marks (Ml, M2, M11, M12) in the display (7),
moving the table supporter (210) to the fourth position and displaying an image of a reference line (RL) of the transfer roller (310; 410) that is imaged by the third imager (21) and an image of a reference line (RL) of the transfer roller (310; 410) that is imaged by the fourth imager (22) in the display (7) with the calibration plate (CP) removed from the table (201) after the adjusting the first to fourth imagers (11, 12, 21, 22), and
adjusting an orientation of the rotation shaft (320; 420) of the transfer roller (310; 410) in a plane parallel to the support surface (201a) after the displaying the image of the reference line (RL) such that the third reference index (VP) of the third imager and the fourth reference index (VP) of the fourth imager (22) are respectively positioned on the reference line (RL).

## Patentansprüche

1. Transfervorrichtung (100) für ein elektronisches Gerät, wobei die Transfervorrichtung fähig ist, eine Kalibrierung unter Verwendung einer Kalibrierplatte (CP) durchzuführen, die erste und zweite Ausrichtungsmarkierungen (M1 und M2), die in einer ersten Richtung (D1) angeordnet sind, und dritte und vierte Ausrichtungsmarkierungen (M11 und M12) aufweist, die in einer zweiten Richtung (D2) orthogonal zur ersten Richtung (D1) angeordnet sind, und einen Transfergegenstand, wobei der Transfergegenstand einen Teil der oder alle funktionalen Materialien umfasst, die das elektronische Gerät oder einen Teil der oder alle elektronischen Komponenten bilden, die das elektronische Gerät bilden, zu einem Objekt transferiert, wobei die Transfervorrichtung (100) umfasst:
einen Tisch (201) mit einer Auflagefläche (201a), die die Kalibrierplatte (CP) und das Objekt selektiv trägt;
einen Tischträger (210), der den Tisch (201) so trägt, dass der Tisch (201) in den ersten und zweiten Richtungen (D1 und D2), die parallel zur Auflagefläche (201a) und orthogonal zueinander sind, beweglich ist, und den Tisch (201) so trägt, dass der Tisch (201) um eine zur Auflagefläche (201a) orthogonale Achse drehbar ist;
einen Bewegungsantrieb (220), der den Tischträger (210) in der ersten Richtung (D1) zwischen einer ersten, einer zweiten, einer dritten und einer vierten Position bewegt;
eine Transferwalze (310; 410), die eine Drehwelle (320; 420) und eine äußere Umfangsfläche aufweist, die den Transfergegenstand hält und eine zur Drehwelle (320; 420) parallele Referenzlinie (RL) enthält;
einen Wellenträger (341), der die Transferwalze (310; 410) so trägt, dass die Transferwalze (310; 410) um die Drehwelle (320; 420) drehbar ist;
einen Drehantrieb (351), der die Transferwalze (310; 410) dreht;
einen ersten Bildgeber (11), der ein Sichtfeld (AA) aufweist, das einen ersten Referenzindex (VP) enthält, und konfiguriert ist zum: - Abbilden der ersten Ausrichtungsmarkierung (M1), wenn der Tischträger (210) in der ersten Position ist, wobei die Kalibrierplatte (CP) von dem Tisch (201) tragen wird, - Abbilden der zweiten Ausrichtungsmarkierung (M2), wenn der Tischträger (210) in der zweiten Position ist, wobei die Kalibrierplatte (CP) von dem Tisch (201) getragen wird, und - Abbilden der dritten Ausrichtungsmarkierung (M11), wenn der Tisch (201), der die Kalibrierplatte (CP) trägt, in der dritten Position ist;
einen zweiten Bildgeber (12), der ein Sichtfeld (AA) aufweist, das einen zweiten Referenzindex (VP) enthält, und konfiguriert ist zum Abbilden der vierten Ausrichtungsmarkierung (M12), wenn der Tischträger (210) in der dritte Position ist, wobei die Kalibrierplatte (CP) von dem Tisch (201) getragen wird;
einen dritten Bildgeber (21), der ein Sichtfeld (AB) aufweist, das sich gemeinsam mit dem Tischträger (210) bewegt und einen dritten Referenzindex (VP) enthält, und konfiguriert ist zum Abbilden der dritten Ausrichtungsmarkierung (M11) der Kalibrierplatte (CP), wenn der Tischträger (210) in der dritten Position ist, wobei die Kalibrierplatte (CP) von dem Tisch (201) getragen wird, und zum Abbilden der Referenzlinie (RL) der Transferwalze (310; 410), wenn der Tischträger (210) in der vierten Position ist; und
einen vierten Bildgeber (22), der ein Sichtfeld (AB) aufweist, das sich gemeinsam mit dem Tischträger (210) bewegt und einen vierten Referenzindex (VP) enthält, und konfiguriert ist zum Abbilden der vierten Ausrichtungsmarkierung (M12) der Kalibrierplatte (CP), wenn der Tischträger (210) in der dritten Position ist, wobei die Kalibrierplatte (CP) von dem Tisch (201) getragen wird, und zum Abbilden der Referenzlinie (RL) der Transferwalze (310; 410), wenn der Tischträger (210) in der vierten Position ist; und
eine Anzeige (7), die Bilder anzeigt, die durch die ersten, zweiten, dritten und vierten Bildgeber (11, 12, 21, 22) aufgenommen sind,
wobei die ersten und zweiten Bildgeber (11, 12) so vorgesehen sind, dass die Positionen der ersten und zweiten Bildgeber (11, 12) unabhängig vom Tischträger (210) einstellbar sind, die dritten und vierten Bildgeber so vorgesehen sind, dass die Positionen der dritten und vierten Bildgeber (21, 22) relativ zum Tisch (201) einstellbar sind,
und die Transferwalze (310; 410) so vorgesehen ist, dass eine Ausrichtung der Drehwelle (320; 420) der Transferwalze (310; 410) zumindest in einer zur Auflagefläche (201a) parallelen Ebene einstellbar ist.

2. Transfervorrichtung (100) für das elektronische Gerät nach Anspruch 1, ferner umfassend:
einen ersten Detektor (91), der sich gemeinsam mit dem Tischträger (210) bewegt und konfiguriert ist, um einen Abstand von einer ersten Detektionsposition zur äußeren Umfangsfläche der Transferwalze (310; 410) zu detektieren; und einen zweiten Detektor (92), der sich gemeinsam mit dem Tischträger (210) bewegt und konfiguriert ist, um einen Abstand von einer zweiten Detektionsposition zur äußeren Umfangsfläche der Transferwalze (310; 410) zu detektieren, wobei die erste Detektionsposition und die zweite Detektionsposition auf einer gemeinsamen Linie positioniert sind, die sich in der zweiten Richtung (D2) erstreckt, um voneinander getrennt zu sein, und
die Transferwalze (310; 410) ferner so vorgesehen ist, dass eine Orientierung der Drehwelle (320; 420) in einer zur zweiten Richtung (D2) parallelen Ebene und in einer dritten Richtung (D3), die zur Auflagefläche (201a) orthogonal ist, einstellbar ist.

3. Transfervorrichtung (100) für das elektronische Gerät nach Ansprüchen 1 oder 2, wobei der Transfergegenstand von einem flächigen Element (SM) gehalten wird, das so konfiguriert ist, dass es an der Transferwalze (310, 410) anbringbar und davon lösbar ist,
das flächige Element (SM) fünfte und sechste Ausrichtungsmarkierungen (SM1 und SM2) aufweist,
die äußere Umfangsfläche der Transferwalze (310; 410) siebte und achte Ausrichtungsmarkierungen (RA1 und RA2) enthält, die in einer Richtung parallel zur Drehwelle (320; 420) angeordnet sind,
die Transfervorrichtung (100) ferner enthält:
einen fünften Bildgeber (31), der ein Sichtfeld (AC) aufweist, das einen fünften Referenzindex (VP) enthält, und konfiguriert ist, um die siebte Ausrichtungsmarkierung (RA1) abzubilden, wenn sich die Transferwalze (310; 410) unter einem vorab festgelegten Drehwinkel befindet, wobei das flächige Element (SM) nicht an der Transferwalze (310; 410) angebracht ist, und zum Abbilden der fünften Ausrichtungsmarkierung (SM1), wenn sich die Transferwalze (310; 410) unter dem vorab festgelegten Drehwinkel befindet, wobei das flächige Element (SM) an der Transferwalze (310; 410) angebracht ist, und einen sechsten Bildgeber (32), der ein Sichtfeld (AC) aufweist, das einen sechsten Referenzindex (VP) enthält, und konfiguriert ist zum Abbilden der achten Ausrichtungsmarkierung(RA2), wenn sich die Transferwalze (310; 410) unter dem vorab festgelegten Drehwinkel befindet, wobei das flächige Element (SM) nicht an der Transferwalze (310; 410) angebracht ist, und zum Abbilden der sechsten Ausrichtungsmarkierung (SM2), wenn sich die Transferwalze (310; 410) unter dem vorab festgelegten Drehwinkel befindet, wobei das flächige Element (SM) an der Transferwalze (310; 410) angebracht ist,
die Anzeige (7) ferner Bilder anzeigt, die von den fünften und sechsten Bildgebern (31, 32) aufgenommen sind, und
die fünften und sechsten Bildgeber (31, 32) so vorgesehen sind, dass die Positionen der fünften und sechsten Bildgeber (31, 32) unabhängig von der Transferwalze (310; 410) einstellbar sind.

4. Transfervorrichtung (100) für das elektronische Gerät nach einem der Ansprüche 1 bis 3, mit einer Vielzahl von Transferwalzen (310; 410), wobei
der Wellenträger (341) konfiguriert ist, um jede der Vielzahl von Transferwalzen (310; 410) drehbar zu tragen,
der Drehantrieb (351) konfiguriert ist, um die Vielzahl von Transferwalzen (310; 410) jeweils zu drehen, und
die vierte Position als jede einer Vielzahl von Positionen eingestellt ist, die jeweils der Vielzahl von Transferwalzen (310; 410) entsprechen.

5. Transferverfahren für ein elektronisches Gerät, enthaltend die Schritte:
Vorbereiten der Transfervorrichtung (100) für das elektronische Gerät nach einem der Ansprüche 1 bis 4;
Kalibrieren der Transfervorrichtung (100); und
Transferieren eines Transfergegenstands zu einem Objekt unter Verwendung der kalibrierten Transfervorrichtung (100), wobei das Kalibrieren die Schritte enthält:
Anordnen der Kalibrierplatte (CP) auf der Auflagefläche (201a) des Tisches (201),
Bewegen des Tischträgers (210) zur ersten Position und Anzeigen eines Bildes von der ersten Ausrichtungsmarkierung (M1), das von dem ersten Bildgeber (11) aufgenommen ist, auf der Anzeige (7), wobei die Kalibrierplatte (CP) von dem Tisch (201) getragen wird,
Einstellen einer Position des ersten Bildgebers (11), so dass der erste Referenzindex (VP) des ersten Bildgebers (11) auf der ersten Ausrichtungsmarkierung (M1) positioniert ist, wenn der Tischträger (210) in der ersten Position ist, wobei die Kalibrierplatte (CP) von dem Tisch (210) getragen wird,
Bewegen des Tischträgers (210) zur zweiten Position und Anzeigen eines Bildes von der zweiten Ausrichtungsmarkierung (M2), das von dem ersten Bildgeber (11) aufgenommen ist, auf der Anzeige (7), wobei die Kalibrierplatte(CP) von dem Tisch (201) getragen wird, nach dem Einstellen der Position des ersten Bildgebers (11),,
Einstellen einer Position des Tisches (201) , der die Kalibrierplatte (CP) trägt, durch den Tischträger (210), so dass der erste Referenzindex (VP) des ersten Bildgebers (11) auf der ersten Ausrichtungsmarkierung (M1) positioniert ist, wenn der Tischträger (210) in der ersten Position ist, wobei die Kalibrierplatte (CP) von dem Tisch (201) getragen wird, und Einstellen der Position des Tisches (201), der die Kalibrierplatte (CP) trägt, durch den Tischträger (210), so dass der erste Referenzindex (VP) des ersten Bildgebers (11) auf der zweiten Ausrichtungsmarkierung (M2) positioniert ist, wenn der Tischträger (210) in der zweiten Position ist, wobei die Kalibrierplatte (CP) von dem Tisch (201) getragen wird, nach dem Einstellen der Position des ersten Bildgebers (11);
Bewegen des Tischträgers (210) zur dritten Position und Anzeigen eines Bildes von der dritten Ausrichtungsmarkierung (M11), das von dem ersten Bildgeber (11) aufgenommen ist, eines Bildes von der vierten Ausrichtungsmarkierung (M12), das von dem zweiten Bildgeber (12) aufgenommen ist, eines Bildes von der dritten Ausrichtungsmarkierung (M11), das vom dritten Bildgeber (21) aufgenommen ist, und eines Bildes von der vierten Ausrichtungsmarkierung (M4), das von dem vierten Bildgeber (22) aufgenommen ist, wobei die Kalibrierplatte (CP) von dem Tisch (201) getragen wird, nach dem Einstellen der Position des Tisches (201),
Einstellen einer Position des ersten Bildgebers (11), so dass der erste Referenzindex (VP) des ersten Bildgebers (11) auf der dritten Ausrichtungsmarkierung (M11) positioniert ist, Einstellen einer Position des zweiten Bildgebers (12), so dass der zweite Referenzindex (VP) des zweiten Bildgebers (12) auf der vierten Ausrichtungsmarkierung (M12) positioniert ist, Einstellen einer relativen Positionsbeziehung zwischen dem dritten Bildgeber (21) und dem Tisch (201), so dass der dritte Referenzindex (VP) des dritten Bildgebers (21) auf der dritten Ausrichtungsmarkierung (M11) positioniert ist, und Einstellen einer relativen Positionsbeziehung zwischen dem vierten Bildgeber (22) und dem Tisch (201), so dass der vierte Referenzindex (VP) des vierten Bildgebers (22) auf der vierten Ausrichtungsmarkierung (M12) positioniert ist, nach Anzeigen der Bilder von den ersten bis vierten Ausrichtungsmarkierungen (M1, M2, M11, M12) auf der Anzeige (7),
Bewegen des Tischträgers (210) zur vierten Position und Anzeigen eines Bildes von einer Referenzlinie (RL) der Transferwalze (310; 410), das von dem dritten Bildgeber (21) aufgenommen ist, und eines Bildes von einer Referenzlinie (RL) der Transferwalze (310; 410), das von dem vierten Bildgeber (22) aufgenommen ist, auf der Anzeige (7), wobei die Kalibrierplatte (CP) vom Tisch (201) entfernt ist, nach dem Einstellen der ersten bis vierten Bildgeber (11, 12, 21, 22), und
Einstellen einer Orientierung der Drehwelle (320; 420) der Transferwalze (310; 410) in einer zur Auflagefläche (201a) parallelen Ebene nach dem Anzeigen des Bildes von der Referenzlinie (RL), so dass der dritte Referenzindex (VP) des dritten Bildgebers (21) und der vierte Referenzindex (VP) des vierten Bildgebers (22) jeweils auf der Referenzlinie (RL) positioniert sind.

## Revendications

1. Un dispositif de transfert (100) pour un dispositif électronique et ce dispositif de transfert (100) est en mesure d'effectuer un calibrage en faisant appel à une plaque de calibrage (CP) qui comporte un premier repère d'alignement (M1) et un deuxième repère d'alignement (M2) qui sont disposés dans un premier sens (D1) et un troisième repère d'alignement (M11) et un quatrième repère d'alignement (M12) qui sont disposés dans un deuxième sens (D2) et ce deuxième sens est perpendiculaire au premier sens (D1) et d'exécuter le transfert d'un article de transfert, et ledit article de transfert se compose d'une partie ou de la totalité des composants fonctionnels qui constituent le dispositif électronique, jusqu'à un objet, et ledit dispositif de transfert (100) se compose des éléments suivants :
une table (201) qui a une surface de support (201a) qui soutient, de manière sélective, la plaque de calibrage (CP) et l'objet
un dispositif de soutien de table (210) qui soutient la table (201) de manière à ce que la table (201) puisse se déplacer dans le premier sens (D1) et dans le deuxième sens (D2), parallèlement à la surface de support (201a), et à la perpendiculaire l'un de l'autre, et qui soutient la table (201) de manière à ce que la table (201) puisse tourner autour d'un axe, à la perpendiculaire de la surface de support (201a)
un dispositif de transmission de mouvement (220) qui déplace le dispositif de soutien de table (210) dans le premier sens (D1) pour l'amener à une première, une deuxième, une troisième et une quatrième positions
un rouleau de transfert (310, 410) qui a un arbre de rotation (320, 420) et une surface périphérique externe qui maintient en place l'article de transfert et comporte une ligne de référence (RL) parallèle à l'arbre de rotation (320, 420)
un dispositif de soutien d'arbre (341) qui supporte le rouleau de transfert (310, 410) de manière à ce que le rouleau de transfert (310, 410) puisse tourner autour de l'axe de rotation (320, 420)
un dispositif de transmission de rotation (351) qui fait tourner le rouleau de transfert (310,410)
un premier imageur (11) qui a un champ de vision (AA) comportant un premier indice de référence (VP) et qui est configuré pour :
reproduire sous forme d'image le premier repère d'alignement (M1) lorsque le dispositif de soutien de table (210) occupe la première position alors que la plaque de calibrage (CP) est soutenue par la table (201)
reproduire sous forme d'image le deuxième repère d'alignement (M2) lorsque le dispositif de soutien de table (210) occupe la deuxième position alors que la plaque de calibrage (CP) est soutenue par la table (201) et
reproduire sous forme d'image le troisième repère d'alignement (M11) lorsque la table (201) soutenant la plaque de calibrage (CP) occupe la troisième position
un deuxième imageur (12) qui a un champ de vision (AA) comportant un deuxième indice de référence (VP) et qui est configuré pour reproduire sous forme d'image le quatrième repère d'alignement (M12) lorsque le dispositif de soutien de table (210) occupe la troisième position alors que la plaque de calibrage (CP) est soutenue par la table (201) et
un troisième imageur (21) qui a un champ de vision (AB) qui se déplace avec le dispositif de soutien de table (210) et comporte un troisième indice de référence (VP) et est configuré pour reproduire sous forme d'image le troisième repère d'alignement (M11) de la plaque de calibrage (CP) lorsque le dispositif de soutien de table (210) occupe la troisième position alors que la plaque de calibrage (CP) est soutenue par la table (201) et pour reproduire sous forme d'image la ligne de référence (RL) du rouleau de transfert (310, 410) lorsque le dispositif de soutien de table (210) occupe la quatrième position et
un quatrième imageur (22) qui a un champ de vision (AB) qui se déplace avec le dispositif de soutien de table (210) et comporte un quatrième indice de référence (VP) et est configuré pour reproduire sous forme d'image le quatrième repère d'alignement (M12) de la plaque de calibrage (CP) lorsque le dispositif de soutien de table (210) occupe la troisième position alors que la plaque de calibrage (CP) est soutenue par la table (201) et pour reproduire sous forme d'image la ligne de référence (RL) du rouleau de transfert (310, 410) lorsque le dispositif de soutien de table (210) occupe la quatrième position et
un écran d'affichage (7) qui affiche des images reproduites par le premier, le deuxième, le troisième et le quatrième imageurs (11, 12, 21, 22) et
le premier et le deuxième imageurs (11, 12) sont équipés de telle sorte que les positions du premier et du deuxième imageurs (11, 12) peuvent se régler indépendamment du dispositif de soutien de table (210) alors que les troisième et quatrième imageurs (21, 22) sont équipés de telle sorte que les positions du troisième et du quatrième imageurs (21, 22) peuvent se régler par rapport à la table (201) alors que le rouleau de transfert (310, 410) est équipé de telle sorte qu'une orientation de l'arbre de rotation (320, 420) du rouleau de transfert (310, 410) peut se régler au moins dans un plan parallèle à la surface de support (201a).

2. Le dispositif de transfert (100) pour le dispositif électronique que décrit la revendication 1, si ce n'est qu'il comporte, en outre, les éléments suivants :
un premier détecteur (91) qui se déplace avec le dispositif de soutien de table (210) et qui est configuré pour détecter une distance entre une première position de détection et la surface périphérique externe du rouleau de transfert (310, 410) et
un deuxième détecteur (92) qui se déplace avec le dispositif de soutien de table (210) et qui est configuré pour détecter une distance entre une deuxième position de détection et la surface périphérique externe du rouleau de transfert (310, 410) et si ce n'est que la première position de détection et la deuxième position de détection sont disposées sur une ligne commune qui se trouve dans le deuxième sens (D2) et sont séparées l'une de l'autre et
le rouleau de transfert (310, 410) est en outre équipé de telle sorte qu'une orientation de l'arbre de rotation (320, 420) peut se régler dans un plan parallèle au deuxième sens (D2) et dans un troisième sens (D3) qui se trouve à la perpendiculaire de la surface de support (201a).

3. Le dispositif de transfert (100) pour le dispositif électronique que décrit la revendication 1 ou 2, si ce n'est que l'article de transfert est maintenu en place par un élément du type feuillard (SM) qui est configuré pour se fixer sur le rouleau de transfert (310, 410) et pour s'en détacher et cet élément du type feuillard (SM) a cinquième et sixième repères d'alignement (SM1 et SM2) et
la surface périphérique externe du rouleau de transfert (310, 410) comporte un septième et un huitième repères d'alignement (RA1 et RA2) qui sont disposés dans un sens parallèle à l'arbre de rotation (320, 420) et
le dispositif de transfert (100) comporte, en outre :
un cinquième imageur (31) qui a un champ de vision (AC) qui comporte un cinquième indice de référence (VP) et qui est configuré pour reproduire sous forme d'image le septième repère d'alignement (RA1) lorsque le rouleau de transfert (310, 410) occupe un angle prédéterminé de rotation alors que l'élément du type feuillard (SM) n'est pas rattaché au rouleau de transfert (310, 410) et pour reproduire sous forme d'image le cinquième repère d'alignement (SM1) lorsque le rouleau de transfert (310, 410) occupe l'angle prédéterminé de rotation alors que l'élément du type feuillard (SM) est rattaché au rouleau de transfert (310, 410) et
un sixième imageur (32) qui a un champ de vision (AC) qui comporte un sixième indice de référence (VP) et qui est configuré pour reproduire sous forme d'image le huitième repère d'alignement (RA2) lorsque le rouleau de transfert (310, 410) occupe l'angle prédéterminé de rotation alors que l'élément du type feuillard (SM) n'est pas rattaché au rouleau de transfert (310, 410) et pour reproduire sous forme d'image le sixième repère d'alignement (SM2) lorsque le rouleau de transfert (310, 410) occupe l'angle prédéterminé de rotation alors que l'élément du type feuillard (SM) est rattaché au rouleau de transfert (310, 410)
l'écran d'affichage (7) présente en outre des images qui sont reproduites sous forme d'images par le cinquième et le sixième imageurs (31, 32) et
le cinquième et le sixième imageurs (31, 32) sont équipés de telle sorte que les positions du cinquième et du sixième imageurs (31, 32) peuvent se régler indépendamment du rouleau de transfert (310, 410).

4. Le dispositif de transfert (100) pour le dispositif électronique que décrit l'une ou l'autre des revendications 1 à 3, si ce n'est qu'il comporte une pluralité de rouleaux de transfert (310, 410) et si ce n'est que le dispositif de soutien d'arbre (341) est configuré pour soutenir, sur le plan rotatif, chaque unité de la pluralité de rouleaux de transfert (310, 410), le dispositif de transmission de rotation (351) est configuré pour, respectivement, faire tourner la pluralité de rouleaux de transfert (310, 410) et
la quatrième position est programmée pour chacune d'une pluralité de positions qui correspondent, respectivement, à la pluralité de rouleaux de transfert (310, 410).

5. Un procédé de transfert pour un dispositif électronique et ce procédé se compose des étapes suivantes :
la préparation du dispositif de transfert (100) pour le dispositif électronique que décrit l'une ou l'autre des revendication 1 à 4,
le calibrage du dispositif de transfert (100) et
le transfert d'un article de transfert jusqu'à un objet en faisant appel au dispositif de transfert (100) calibré, et ce calibrage se compose des étapes suivantes :
le positionnement de la plaque de calibrage (CP) sur la surface de support (201a) de la table (201)
le déplacement du dispositif de soutien de table (210) pour l'amener à la première position et l'affichage d'une image du premier repère d'alignement (M1) reproduite sous forme d'image par le premier imageur (11) sur l'écran d'affichage (7), lorsque la plaque de calibrage (CP) est soutenue par la table (201)
le réglage d'une position du premier imageur (11), de telle sorte que le premier indice de référence (VP) du premier imageur (11) vient se positionner sur le premier repère d'alignement (M1) lorsque le dispositif de soutien de table (210) occupe la première position, lorsque la plaque de calibrage (CP) est soutenue par la table (201)
le déplacement du dispositif de soutien de table (210) pour l'amener à la deuxième position et l'affichage d'une image du deuxième repère d'alignement (M2) reproduite sous forme d'image par le premier imageur (11) sur l'écran d'affichage (7), lorsque la plaque de calibrage (CP) est soutenue par la table (201), après le réglage de la position du premier imageur (11)
le réglage d'une position de la table (201) qui soutient la plaque de calibrage (CP) par le biais du dispositif de soutien de table (210), de telle sorte que le premier indice de référence (VP) du premier imageur (11) vient se positionner sur le premier repère d'alignement (M1), lorsque le dispositif de soutien de table (210) occupe la première position, lorsque la plaque de calibrage (CP) est soutenue par la table (201) et
le réglage de la position de la table (201) qui soutient la plaque de calibrage (CP) par le biais du dispositif de soutien de table (210), de telle sorte que le premier indice de référence (VP) du premier imageur (11) vient se positionner sur le deuxième repère d'alignement (M2), lorsque le dispositif de soutien de table (210) occupe la deuxième position, alors que la plaque de calibrage (CP) est soutenue par la table (201), après le réglage de la position du premier imageur (11)
le déplacement du dispositif de soutien de table (210) pour l'amener à la troisième position et l'affichage d'une image du troisième repère d'alignement (M11) qui est reproduite, sous forme d'image, par le premier imageur (11), une image du quatrième repère d'alignement (M12) qui est reproduite, sous forme d'image, par le deuxième imageur (12), une image du troisième repère d'alignement (M11) qui est reproduite, sous forme d'image, par le troisième imageur (21) et une image du quatrième repère d'alignement (M4) qui est reproduite, sous forme d'image, par le quatrième imageur (22), lorsque la plaque de calibrage (CP) est soutenue par la table (201), après le réglage de la position de la table (201)
le réglage d'une position du premier imageur (11), de telle sorte que le premier indice de référence (VP) du premier imageur (11) vient se positionner sur le troisième repère d'alignement (M11), le réglage d'une position du deuxième imageur (12), de telle sorte que le deuxième indice de référence (VP) du deuxième imageur (12) vient se positionner sur le quatrième repère d'alignement (M12), le réglage d'un rapport positionnel relatif entre le troisième imageur (21) et la table (201), de telle sorte que le troisième indice de référence (VP) du troisième imageur (21) vient se positionner sur le troisième repère d'alignement (M11), et le réglage d'un rapport positionnel relatif entre le quatrième imageur (22) et la table (201), de telle sorte que le quatrième indice de référence (VP) du quatrième imageur (22) vient se positionner sur le quatrième repère d'alignement (M12), après l'affichage des images des premiers aux quatrièmes repères d'alignement (M1, M2, M11, M12) sur l'écran d'affichage (7)
le déplacement du dispositif de soutien de table (210) pour l'amener à la quatrième position et l'affichage d'une image d'une ligne de référence (RL) du rouleau de transfert (310, 410), qui est reproduite, sous la forme d'image, par le troisième imageur (21) et une image d'une ligne de référence (RL) du rouleau de transfert (310, 410), qui est reproduite, sous la forme d'image, par le quatrième imageur (22) sur l'écran d'affichage (7), lorsque la plaque de calibrage (CP) a été retirée de la table (201), après le réglage des premiers aux quatrièmes imageurs (11, 12, 21, 22) et
le réglage d'une orientation de l'arbre de rotation (320, 420) du rouleau de transfert (310, 410) sur un plan parallèle à la surface de support (201a), après l'affichage de l'image de la ligne de référence (RL), de telle sorte que le troisième indice de référence (VP) du troisième imageur (21) et le quatrième indice de référence (VP) du quatrième imageur (22) viennent, respectivement, se positionner sur la ligne de référence (RL).
